(19) Europäisches Patentamt / European Patent Office / Office européen des brevets

(11) **EP 2 924 599 A1**

(12) # EUROPEAN PATENT APPLICATION

(43) Date of publication:
**30.09.2015 Bulletin 2015/40**

(51) Int Cl.:
**G06F 17/50** (2006.01)          **G06F 17/30** (2006.01)

(21) Application number: **15157546.1**

(22) Date of filing: **04.03.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **28.03.2014 JP 2014070456**

(71) Applicant: **FUJITSU LIMITED**
**Kawasaki-shi,**
**Kanagawa 211-8588 (JP)**

(72) Inventors:
• **Noma, Yui**
  **Kanagawa 211-8588 (JP)**
• **Konoshima, Makiko**
  **Kanagawa 211-8588 (JP)**

(74) Representative: **Hoffmann Eitle**
**Patent- und Rechtsanwälte PartmbB**
**Arabellastraße 30**
**81925 München (DE)**

(54) **Computing program, computing apparatus and computing method**

(57)     A storage unit stores information on a graph corresponding to a structure data set that represents a three-dimensional structure with a plurality of polygons. An operation unit obtains the information on the graph from the storage unit. The operation unit determines a degree and parameter to be used in the operation of a symmetric polynomial, on the basis of the information on the graph, and then calculates a feature value of the graph corresponding to the structure data set with the symmetric polynomial using the determined degree and parameter.

FIG. 1

**Description**

FIELD

The embodiments discussed herein relate to a computing program, a computing apparatus and a computing method.

BACKGROUND

There have been used software tools that assist in drawing three-dimensional models. For example, Computer-Aided Design (CAD) is one of techniques for helping designers create designs. A computer running the CAD software creates the three-dimensional model of a structure in accordance with user inputs made on input devices and displays the three-dimensional model on a display. The user is able to work on manipulating the three-dimensional model of the structure while visually recognizing it on the display.

For example, computers are able to display three-dimensional graphics based on three-dimensional coordinate information. Standard Triangulated Language (STL) is an example of data format for representing three-dimensional shapes. In the STL, the shape of a three-dimensional model is represented with a combination of a plurality of triangles. With respect to one triangle, STL data includes information about the coordinates of three vertices and the normal vector to the surface of the triangle.

By the way, there may be a case of performing a search based on a specific three-dimensional model to find other three-dimensional models. For example, during the course of designing, such a search is made to confirm whether a component having a similar shape to a target component has been designed, so as to reduce redundant designing. To this end, there has been considered a method of searching for three-dimensional models having similar shapes to a target three-dimensional model. For example, the features of the shape of a three-dimensional model are quantified. Three-dimensional models having similar feature values are considered to have similar shapes. The search may be made using feature vectors each including a plurality of kinds of feature values.

For example, there has been proposed a method of transforming a three-dimensional object into a skeleton graph through voxelization and thinning, further processing the skeleton graph, and detecting graph-related feature vector elements (the number of ridge loops, nodes, and so on) for search. In addition, there have been other proposals that use the volume of a three-dimensional model, the radius of a bounding sphere (a sphere whose radius is half the length of the longest axis of an object model), a color histogram, a wavelet coefficient, or another as a feature descriptor in searching three dimensional images.

Please see, for example, Japanese National Publications of International Patent Applications Nos. 2006-520948 and 2003-518294.

In the case of representing the three-dimensional shape of a structure with a combination of polygons, each vertex of the structure is represented as a vertex of the polygons, and each side connecting two vertex of the structure is represented as a side of the polygons. In this case, the vertices of the structure and the sides connecting two vertices of the structure are depicted as nodes and edges, a weighted graph that assigns a prescribed weight to every node and edge is generated from structure data, and the feature values of the weighted graph are obtained as the feature values of the structure data. This approach has a problem of how to efficiently obtain the feature values appropriate for structure data search.

For example, there is a requirement that the feature values of a graph to be used for shape search are not affected by the numbering order of nodes (i.e., symmetric group invariance). However, in the case of calculating symmetric group invariant values from the weights of nodes or any values that do not have a symmetry property, the computational cost may significantly increase with the number of nodes.

SUMMARY

According to one aspect, it is an objective to provide a computing program, computing apparatus, and computing method for efficiently calculating feature values appropriate for structure data search.

According to one aspect, there is provided a computing program that causes a computer to perform a process including: obtaining information on a graph corresponding to a structure data set, the structure data set representing a three-dimensional structure with a plurality of polygons; determining a degree and parameter to be used in an operation of a symmetric polynomial based on the information; and calculating a feature value of the graph corresponding to the structure data set with the symmetric polynomial using the determined degree and parameter.

BRIEF DESCRIPTION OF DRAWINGS

FIG. 1 illustrates a computing apparatus according to a first embodiment;
FIG. 2 illustrates an exemplary hardware configuration of a computing apparatus according to a second embodiment;
FIGS. 3A and 3B illustrate an exemplary polygon and structure;
FIG. 4 illustrates exemplary functions of the computing apparatus;
FIGS. 5A, 5B, and 5C are exemplary skew Young diagrams;
FIG. 6 illustrates an exemplary structure data set;
FIG. 7 illustrates an exemplary graph data set;
FIG. 8 illustrates an exemplary tetrahedron;
FIG. 9 is a flowchart illustrating an example of how to determine an order and parameters;
FIGS. 10 to 17 are flowcharts illustrating first to eighth examples of how to calculate a feature vector; and
FIGS. 18A and 18B illustrate examples of numbering nodes.

DESCRIPTION OF EMBODIMENTS

Several embodiments will be described below with reference to the accompanying drawings, wherein like reference numerals refer to like elements throughout.

(First Embodiment)

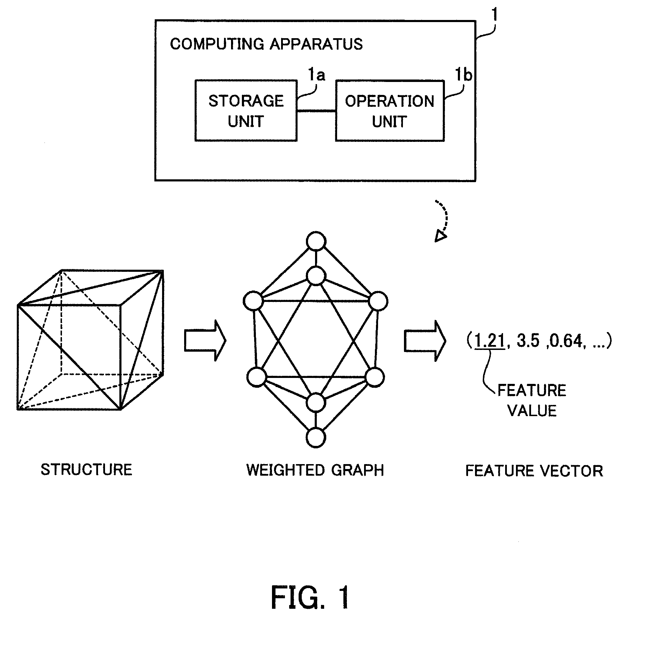

FIG. 1 illustrates a computing apparatus according to a first embodiment. The computing apparatus 1 calculates feature values of structure data sets each representing a three-dimensional structure. A structure data set here represents a structure with a plurality of polygons. More specifically, the surface of the structure is approximated by a combination of the planes of the plurality of polygons. The term "polygon" may be used to indicate an element forming an object in three-dimensional space. For example, there is an STL data format for representing a structure as a collection of triangle polygons.

The computing apparatus 1 may calculate a plurality of kinds of feature values for one structure data set. The plurality of kinds of feature values may collectively be called a feature vector. For example, feature values (or feature vectors) are used for structure data search. A search device may compare the feature values of the structure data set specified by a search query with the feature values of the structure data sets stored in a library to find other structure data sets representing similar shapes to the specified structure data set from the library. The search result may be displayed on a display connected to the search device or may be sent to a terminal device having issued the search query. The computing apparatus 1 may be provided with such a search function.

For example, the function for searching for similar shapes is used to avoid redundant designing in designing components or others. In addition, when a product fails due to a certain component, the search function is used to check a failure history or the causes of failures with respect to similar components.

The computing apparatus 1 includes a storage unit 1a and an operation unit 1b. The storage unit 1a may be a volatile storage device, such as a Random Access Memory (RAM) or the like, or a non-volatile storage device, such as a Hard Disk Drive (HDD), a flash memory, or the like. The operation unit 1b includes a processor, for example. The processor may be a Central Processing Unit (CPU), a Digital Signal Processor (DSP), or an application-specific electronic circuit, such as an Application Specific Integrated Circuit (ASIC), Field Programmable Gate Array (FPGA), or the like. In addition, the processor may be a set of plural processors (multiprocessor). The processor may execute programs stored in the storage unit 1a, for example.

The storage unit 1a stores information on the graphs corresponding to structure data sets. In a graph, each vertex of the structure represented by a structure data set is depicted as a node, and each side connecting two vertices (nodes) of the structure is depicted as an edge. Nodes connected with an edge are considered to be adjacent to each other. Each vertex of the structure is represented as a vertex of polygons, and each side connecting two vertices of the structure is represented as a side of the polygons. More specifically, each vertex of the structure is represented as a vertex shared by three or more polygons, and each side connecting two vertices of the structure is represented as a side shared by two adjacent polygons.

The graph also assigns a prescribed weight to every node and edge. For example, there is an idea that a distance between the center of gravity and a vertex of a structure is used to represent the weight of the node corresponding to the vertex, and the length of a side is used to represent the weight of the edge corresponding to the side. In this case, the weights of nodes and edges are considered as information reflecting the size of the structure and the shape of the structure including angles between sides thereof. For example, consider the case where a structure has N (N is an integer of four or greater) vertices. The weights of the nodes are expressed as a vector X with N elements, and the weights of the edges are expressed as a matrix W with N rows and N columns.

$$\mathbf{X} = (X_1, X_2, \ldots, X_N) \qquad (1)$$

$$\mathbf{W} = \{W_{ij}\}_{1 \leq i,j \leq N} \qquad (2)$$

In the equation (1), the j-th element (j is an integer satisfying $1 \leq j \leq N$) of the vector X corresponds to the weight of the j-th node. In the equation (2), the i-th row and j-th column element (i is an integer satisfying $1 \leq i \leq N$) corresponds to the weight of an edge connecting the i-th node and the j-th node. In the matrix W, the diagonal elements and elements corresponding to between nodes having no edge therebetween are "0".

The operation unit 1b obtains information on the graph corresponding to a structure data set from the storage unit 1a and determines a degree and parameter to be used in the operation of a symmetric polynomial, on the basis of the obtained information on the graph. The operation unit 1b then calculates a feature value of the graph corresponding to the structure data set with the symmetric polynomial using the determined degree and parameter.

For shape search, there is a requirement that feature values of a graph are not affected by the numbering order of nodes (i.e., symmetric group invariance). Therefore, the operation unit 1b obtains a value (symmetric group invariant value) that is not affected by the numbering order of nodes, from the graph, and takes this value as a feature value of the structure data set. To this end, the operation unit 1b uses a symmetric polynomial. The symmetric polynomial is a polynomial in n variables and has characteristics (symmetric group invariance) in which the polynomial is unchanged if any of the n variables are interchanged. The feature value is calculated in the following manner. First, a matrix D(X) with N rows and N columns is defined for a vector X. Each element in the matrix D(X) is defined by the equation (3).

$$D(X)_{ij} = \delta_{ij} X_i \qquad (3)$$

In this equation (3), the symbol $\delta$ denotes the delta of Kronecker, $\delta_{i=j} = 1$, and $\delta_{i \neq j} = 0$. Then, the following matrix $M^l$ is obtained using the matrix W and the matrix D(X).

$$\mathbf{M}^l = \mathbf{D}(\mathbf{X})\left(\mathbf{WD}(\mathbf{X})\right)^l \qquad (4)$$

The matrix WD(X) describes an operation of transmitting the weight of each node to its adjacent node, taking the weight of a corresponding edge into account. The superscript 1 (1 is an integer of one or greater) in the equation (4), which is a parameter, means that the operation is executed 1 times. In the following, a Newton symmetric polynomial p is considered as one example of symmetric polynomials. A Newton symmetric polynomial $p_k$ of degree k is written as the following equation (5).

$$p_k(x_1, x_2, \ldots, x_n) = \sum_{i=1}^{n} x_i^k \qquad (5)$$

To apply the elements of the matrix $M^l$ to the Newton symmetric polynomial $p_k$, a 2nd-order tensor (the values represented by a matrix M) is transformed into a 1st-order tensor (the values represented by a vector). To this end, one of possible methods is to generate a vector (with N elements) having diagonal elements (diagonal components) of the matrix $M^l$. In this case, the operation unit 1b obtains a symmetric group invariant value $p_{k,l}$ by substituting the diagonal elements of the matrix $M^l$ for the variables of the Newton symmetric polynomial $p_k$, as defined by the equation (6).

$$p_{k,l} = p_k(M_{11}^l, M_{22}^l, \ldots, M_{NN}^l)$$

$$= \sum_{i=1}^{N} \left( \left( D(X)(WD(X))^l \right)_{ii} \right)^k \qquad (6)$$

Note that another method may be used for transforming a 2nd-order tensor into a 1st-order tensor. For example, a vector with a total of N elements may be generated by using the sum of the j-th column elements of the matrix $M^l$ as one element. Alternatively, a vector with a total of N elements may be generated by using the sum of the i-th row elements of the matrix $M^l$ as one element.

Furthermore, a vector with N elements may be generated by substituting the i-th row (or j-th column) elements (N elements) of the matrix $M^l$ into $p_{k,l}$, and then the calculation result may be substituted into the Newton symmetric polynomial. For example, a value $p'_{k,l}$ obtained by calculating N values $p_{k,l}$ using the N j-th column elements and then substituting the calculation result into the Newton symmetric polynomial is written as the following equation (7). The value $p'_{k,l}$ is also symmetric group invariant.

$$p'_{k,l} = p_k \left( p_k(M_{11}^l, M_{21}^l, \ldots, M_{N1}^l), \right.$$
$$p_k(M_{12}^l, M_{22}^l, \ldots, M_{N2}^l), \ldots,$$
$$\left. p_k(M_{1N}^l, M_{2N}^l, \ldots, M_{NN}^l) \right) \qquad (7)$$

The operations of the symmetric polynomials in the equations (6) and (7) use the degree k and parameter 1. The operation unit 1b determines the degree k and parameter 1 on the basis of the information on a graph. For example, the operation unit 1b determines the degree k and parameter 1 on the basis of the distribution of the weights of nodes and edges (for example, a degree of dispersion). For example, a relative error (standard deviation ÷ mean value) in the weights of nodes and edges may be used as a value indicating the degree of dispersion.

More specifically, as a relative error in the weights indicated in the graphs of all (or some) structure data sets registered in the library is greater, a smaller degree k and a smaller parameter 1 are used. In other words, as a relative error in the weights indicated in the graphs of all (or some) structure data sets registered in the library is smaller, a greater degree k and a greater parameter 1 are used.

The operation unit 1b may obtain a relative error with respect to either nodes or edges. A relative error may be obtained with respect to both nodes and edges. When determining that the degree k is K and the parameter 1 is L, the operation unit 1b may calculate a feature value with respect to every combination of integers k and 1 satisfying $1 \leq k \leq K$ and $1 \leq l \leq L$ and may generate a feature vector having the individual feature values as elements.

As described above, the computing apparatus 1 obtains information on the graph corresponding to a structure data set that represents a three-dimensional structure with a plurality of polygons, determines a degree and parameter to be used in the operation of a symmetric polynomial, on the basis of the information on the graph, and calculates a feature value of the graph corresponding to the structure data set with the symmetric polynomial using the determined degree and parameter. This approach makes it possible to efficiently calculate feature values appropriate for structure data search. A specific example will be described below.

There is a requirement that feature values of a graph for shape search are not affected by the numbering order of nodes (i.e., symmetric group invariance). This is because, if feature values of a certain shape vary depending on the numbering order of nodes, a search is not conducted properly.

A computational cost problem occurs in converting values that are not symmetric group invariant into values that are symmetric group invariant (i.e., symmetric group invariant values). Assuming the number of nodes in a graph is N, the order of the symmetric group is N!, and therefore it is not easy to calculate a symmetric group invariant value from the weights of nodes and edges with taking all of the permutations into account.

For example, there is a simple idea of calculating $(x_1^{a1} x_2^{a2} \cdots x_N^{aN}) + (x_2^{a1} x_1^{a2} \cdots x_N^{aN}) + \cdots + (x_N^{a1} x_{N-1}^{a2} \cdots x_1^{aN})$ (the exponents a1, a2, $\cdots$, aN are all different, and the terms of all the different permutations generated by replacing variables with respect to the exponents are summed. The number of terms is N!.), and taking the result as a feature value. However, this calculation has a computational complexity of O(N!) (i.e., a computational amount of O(N!)), and the computational cost greatly increases with an increase in the number of nodes. That is to say, with an increase in the number of vertices of a structure, the computational cost for calculating a feature value becomes considerable. In addition, for example, to solve an NP (Non-deterministic Polynomial time)-hard problem, such as calculating the number of cliques (a subset of nodes in which every two nodes are connected by an edge), needs a considerable computational cost, which is not realistic.

The computing apparatus 1 uses a symmetric polynomial to calculate a feature value, thereby reducing the computational cost needed to calculate a symmetric group invariant value. In the above-described Newton symmetric polynomials, the use of even the equation (7) reduces the computational complexity to $O(N^2)$.

To this end, the computing apparatus 1 determines a degree k and parameter 1 on the basis of information on a graph. As described earlier, the weights of nodes and edges are considered as information reflecting the shape of a structure. For example, as is seen from the equation (6), the number of times of multiplication of weight is obtained by the product kl of the degree k and parameter 1. In general, multiplication enlarges a difference between values. If differences in weight are reflected too much in feature values, a relatively small difference in shape produces a relatively large difference between feature values, which makes it difficult to evaluate similarity by comparison of feature values in searching.

To deal with this, the operation unit 1b dynamically adjusts the degree k and parameter 1 on the basis of information about the weights of a graph so that multiplication does not greatly enlarge differences in weight, thereby making it possible to calculate feature values appropriate for searching for similar shapes. In addition, the computing apparatus 1 is able to limit the number of times of multiplication kl under a prescribed criterion, thereby making it possible to obtain feature values appropriate for search at a relatively low computational cost, compared with the case of using a fixed degree k and parameter 1, irrespective of information on the graph, and thoughtlessly repeating multiplication.

(Second Embodiment)

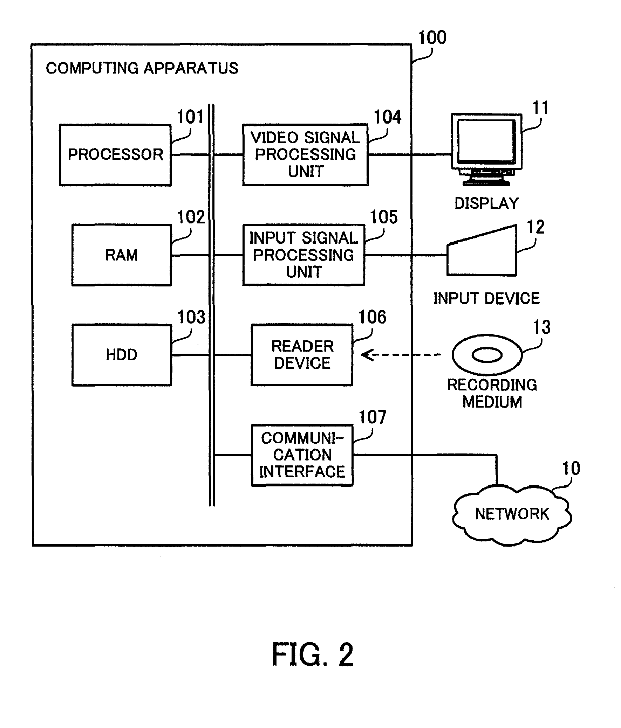

FIG. 2 illustrates an exemplary hardware configuration of a computing apparatus according to a second embodiment. A computing apparatus 100 assists in designing structures in three-dimensional space using a CAD. The computing apparatus 100 displays a three-dimensional image on a display connected thereto in accordance with user operations. The user is able to request the computing apparatus 100 to search the existing data of (already designed) structures.

For example, the user draws a desired three-dimensional structure on the computing apparatus 100, and requests the computing apparatus 100 to find similar structures to the drawn structure. The computing apparatus 100 then searches a library to find structures having similar shapes to the specified structure, and presents the found structures to the user. The library is a database that contains the structure data sets of a variety of designed structures, and is stored in a storage device provided in the computing apparatus 100. The library may be stored in a storage device externally connected to the computing apparatus 100 over a network 10. In the following description, a three-dimensional model (polyhedron) representing the shape of a structure may simply be referred to as a structure.

The computing apparatus 100 includes a processor 101, a RAM 102, an HDD 103, a video signal processing unit 104, an input signal processing unit 105, a reader device 106, and a communication interface 107. Each of these units is connected to a bus in the computing apparatus 100.

The processor 101 controls information processing that is performed by the computing apparatus 100. The processor 101 may be a multiprocessor. The processor 101 is, for example, a CPU, a DSP, an ASIC, an FPGA, or another. The processor 101 may be a combination of two or more selected from a CPU, DSP, ASIC, FPGA, and others.

The RAM 102 is a main storage device of the computing apparatus 100. The RAM 102 temporarily stores at least part of Operating System (OS) programs and application programs to be executed by the processor 101. The RAM 102 also stores various data to be used by the processor 101 in processing.

The HDD 103 is an auxiliary storage device of the computing apparatus 100. The HDD 103 magnetically reads and writes data on a built-in magnetic disk. The HDD 103 stores the OS programs, application programs, and various data. The computing apparatus 100 may be provided with a flash memory, Solid State Drive (SSD) or another auxiliary storage device, or with a plurality of auxiliary storage devices.

The video signal processing unit 104 outputs images to a display 11 connected to the computing apparatus 100 in accordance with instructions from the processor 101. As the display 11, a Cathode Ray Tube (CRT) display, a liquid crystal display, or another display may be used.

The input signal processing unit 105 transfers input signals received from an input device 12 connected to the computing apparatus 100, to the processor 101. As the input device 12, for example, a pointing device, such as a mouse, a digitizer, a touch panel, or the like, a keyboard, etc. may be used.

The reader device 106 reads programs and data from a recording medium 13. As the recording medium 13, for example, a magnetic disk, such as a flexible disk (FD), an HDD, or the like, an optical disc, such as a Compact Disc (CD), a Digital Versatile Disc (DVD), or the like, or a Magneto-Optical disk (MO) may be used. In addition, as the recording medium 13, for example, a flash memory card or another non-volatile semiconductor memory may be used. The reader device 106 stores programs and data read from the recording medium 13 in the RAM 102 or the HDD 103 in accordance with instructions from the processor 101.

The communication interface 107 performs communications with another device over the network 10. The communication interface 107 may be a wired or wireless communication interface.

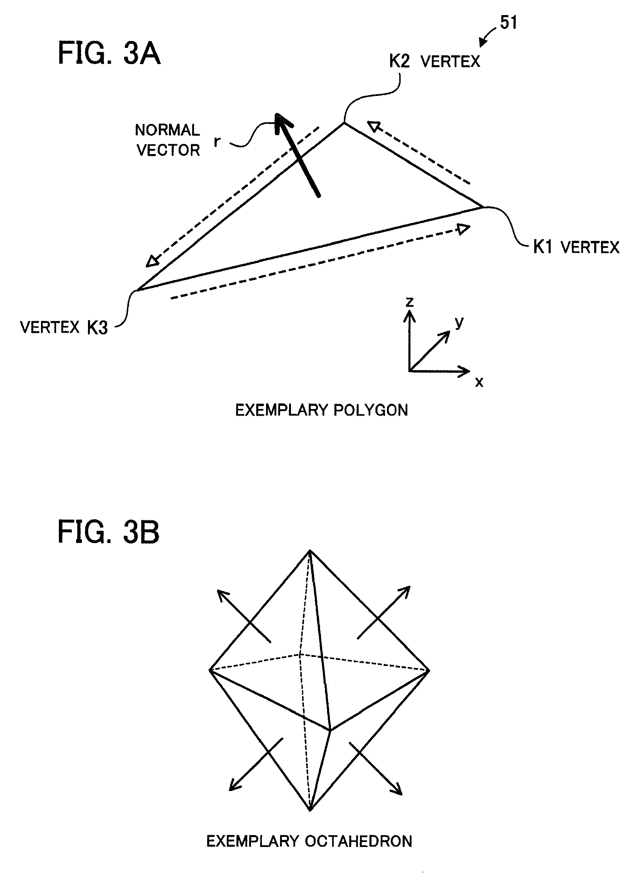

FIGS. 3A and 3B illustrate an exemplary polygon and structure. FIG. 3A exemplifies one of polygons that form a structure. The second embodiment uses triangle polygons by ways of example. The computing apparatus 100 manages polygons using structure data in, for example, STL format. Alternatively, rectangles, pentagons, or other polygons may be used. FIG. 3B exemplifies an octahedron formed by a plurality of polygons. The surface of the octahedron is represented by a combination of the plurality of polygons. FIG. 3B also illustrates the normal vectors of four front-side polygons.

Information on the triangle polygon 51 includes the coordinates of three vertices K1, K2, and K3 and a normal vector r to the front surface of the polygon 51. The normal vector r may have unit length. The coordinates and normal vector may be expressed as coordinates on the three mutually orthogonal axes x, y, and z.

Note that the front and back of the polygon 51 are distinguishable on the basis of the order of defining the coordinates of the three vertices K1, K2, and K3 in the structure data. When viewed from the front side of the polygon 51, the vertices K1, K2, and K3 are defined counterclockwise, starting with a first vertex, then a second vertex, and then a third vertex.

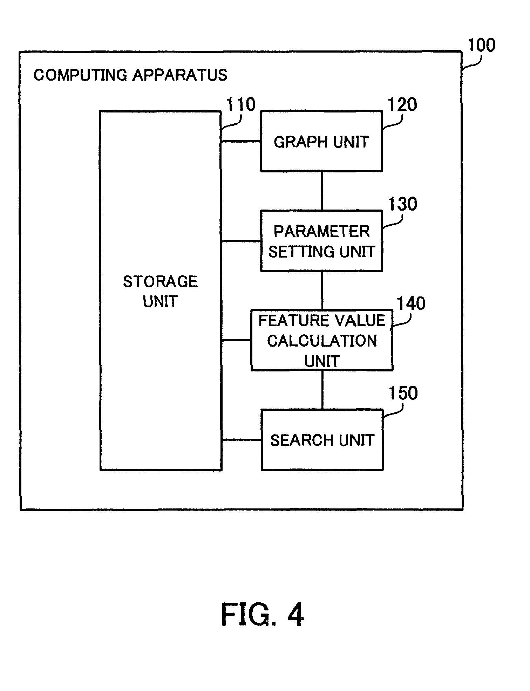

FIG. 4 illustrates exemplary functions of the computing apparatus. The computing apparatus 100 includes a storage unit 110, a graph unit 120, a parameter setting unit 130, a feature value calculation unit 140, and a search unit 150. The storage unit 110 may be implemented by using a storage area prepared in the RAM 102 or the HDD 103. The graph unit 120, parameter setting unit 130, feature value calculation unit 140, and search unit 150 may be implemented as program modules to be executed by the processor 101.

The storage unit 110 stores information to be used by these constituent units. The storage unit 110 stores structure data, graph data, feature vector data, and others. The structure data represents the shapes of structures in STL format. As the stored structure data, there is a plurality of structure data sets, each for one drawn structure. A plurality of structure data sets (a group of structure data sets) in the storage unit 110 may be referred to as "a library".

As the graph data, there is a plurality of graph data sets, each for a graph generated based on a structure data set. Each graph is a weighted graph that assigns a prescribed weight to every node and edge. The feature vector data is used for managing, for each structure data set, a feature vector calculated from a graph data set. If there is a storage device that is accessible from the computing apparatus 100 over the network 10, the computing apparatus 100 may store the structure data, graph data, and feature vector data in that storage device.

The graph unit 120 generates a graph from a structure data set and stores the graph in the storage unit 110. More specifically, the graph unit 120 generates a graph in which each vertex of the structure identified by a structure data set is represented as a node and each side connecting the vertices of the structure is represented as an edge. The graph unit 120 represents the weight of the node corresponding to a vertex of the structure by a distance between the center of gravity and the vertex of the structure, and represents the weight of the edge corresponding to a side by the length of the side.

The parameter setting unit 130 determines parameters and others to be used by the feature value calculation unit 140 for operations. As will be described later, the feature value calculation unit 140 uses symmetric polynomials to calculate feature values. The parameter setting unit 130 determines a degree and parameters to be used in the operation of the symmetric polynomials, on the basis of statistical values in terms of the weights indicated in the graph data set of a structure stored in the storage unit 110.

The feature value calculation unit 140 calculates a feature value based on the weights and connectivity of nodes represented in a graph, with a symmetric polynomial using a degree and parameters determined by the parameter setting unit 130. The feature value calculation unit 140 calculates a plurality of kinds of feature values and takes them as a feature vector of the structure.

The feature value calculation unit 140 calculates a feature vector in advance for each structure data set registered in the library. The feature value calculation unit 140 then registers the calculated feature vectors in the feature vector data stored in the storage unit 110 in association with the structure data sets. The feature value calculation unit 140 may calculate a feature vector for the structure data set specified by a search query.

The search unit 150 receives a search query for a structure. For example, the user manipulates the input device 12 to enter a desired search query in the computing apparatus 100. The search unit 150 may receive such a search query from another information processing apparatus over the network 10. A search query includes a structure data set or information specifying a structure data set.

The search unit 150 obtains a feature vector for the structure data set specified by a search query in cooperation with the graph unit 120, parameter setting unit 130, and feature value calculation unit 140. The search unit 150 then compares the feature vector of the specified structure data set with the feature vectors registered in the feature vector data stored in the storage unit 110 to find structure data sets representing similar shapes to the specified structure data set. For example, to achieve the search, there is an idea of comparing the feature vector of the structure data set specified by a search query with the feature vectors of the structure data sets stored in the library with respect to each element, and determining a structure data set with a smaller total difference as having a higher degree of similarity. The search unit 150 presents the search result to the user by, for example, displaying the result on the display 11.

Note that the feature value calculation unit 140 may use various symmetric polynomials to calculate feature values. Please see the following literature: "Symmetric functions and Hall polynomials second edition (Oxford Mathematical Monographs)" (Ian Grant MacDonald, New York: Oxford University Press, 1995), for symmetric polynomials. For example, the following symmetric polynomials may be considered.

(1) Elementary Symmetric Polynomials

Elementary symmetric polynomials of degrees 0 to 3, $e_0$, $e_1$, $e_2$, and $e_3$, are written as the following equations (8), where the symbols j, k, and 1 are positive integers and the symbol n is a positive integer denoting the number of variables.

$$\begin{cases} e_0(x_1, x_2, \ldots, x_n) &= 1 \\ e_1(x_1, x_2, \ldots, x_n) &= \sum_{1 \leq j \leq n} x_j \\ e_2(x_1, x_2, \ldots, x_n) &= \sum_{1 \leq j < k \leq n} x_j x_k \\ e_3(x_1, x_2, \ldots, x_n) &= \sum_{1 \leq j < k < l \leq n} x_j x_k x_l \\ \vdots \end{cases} \quad (8)$$

(2) Complete Symmetric Polynomials

Complete symmetric polynomials of degrees 1 to 3, $h_1$, $h_2$, and $h_3$, are written as the following equations (9), where the symbols j, k, and 1 are positive integers, and the symbol n is a positive integer denoting the number of variables.

$$\begin{cases} h_1(x_1, x_2, \ldots, x_n) &= \sum_{1 \leq j \leq n} x_j \\ h_2(x_1, x_2, \ldots, x_n) &= \sum_{1 \leq j \leq k \leq n} x_j x_k \\ h_3(x_1, x_2, \ldots, x_n) &= \sum_{1 \leq j \leq k \leq l \leq n} x_j x_k x_l \\ \vdots \end{cases} \quad (9)$$

(3) Monomial Symmetric Polynomials

Assuming that a given positive integer d is partitioned into a sequence of non-increasing and non-negative integers $d_1$, $d_2$, ..., and $d_n$, the sequence of non-negative integers is called a partition of d or an integer partition of d and is denoted by $\lambda$. A relation among d and $d_1$, $d_2$, ..., and $d_n$ is defined by the notation (10).

$$\begin{cases} d = d_1 + d_2 + \cdots + d_n \\ d_1 \geq d_2 \geq \ldots \geq d_n \geq 0 \end{cases} \quad (10)$$

A monomial symmetric polynomial is associated with a partition $\lambda$. For example, the monomial symmetric polynomial associated with a partition $\lambda$ = (3, 1, 1) of d = 5 is written as the equation (11).

$$m_{(3,1,1)}(x_1, x_2, x_3) = x_1^3 x_2 x_3 + x_1 x_2^3 x_3 + x_1 x_2 x_3^3 \qquad (11)$$

In addition, the monomial symmetric polynomial associated with a partition $\lambda$ = (3, 2, 1) of d = 6 is written as the equation (12).

$$m_{(3,2,1)}(x_1, x_2, x_3) = x_1^3 x_2^2 x_3 + x_1^3 x_2 x_3^2$$
$$+ x_1^2 x_2^3 x_3 + x_1^2 x_2 x_3^3$$
$$+ x_1 x_2^3 x_3^2 + x_1 x_2^2 x_3^3 \qquad (12)$$

The integer d for a partition $\lambda$ corresponds to the degree of a polynomial (the same applies to the following polynomials).

(4) Newton Symmetric Polynomials

As exemplified in the first embodiment, a Newton symmetric polynomial of degree k is written as the equation (13), where the symbol k is a positive integer and the symbol n is a positive integer denoting the number of variables.

$$p_k(x_1, x_2, \ldots, x_n) = x_1^k + x_2^k + \cdots + x_n^k$$
$$= \sum_{i=1}^{n} x_i^k \qquad (13)$$

(5) Schur polynomials

A Vandermonde determinant is defined by the equation (14), where the symbols j and k are positive integers and the symbol n is a positive integer denoting the number of variables.

$$a_{(n-1,n-2,\ldots,0)}(x_1, x_2, \ldots, x_n) = \det \begin{bmatrix} x_1^{n-1} & x_2^{n-1} & \cdots & x_n^{n-1} \\ x_1^{n-2} & x_2^{n-2} & \cdots & x_n^{n-2} \\ \vdots & \vdots & \ddots & \vdots \\ 1 & 1 & \cdots & 1 \end{bmatrix}$$

$$= \prod_{1 \leq j < k \leq n} (x_j - x_k) \qquad (14)$$

The Schur polynomial corresponding to a partition $\lambda$ = (d$_1$, d$_2$, ..., d$_n$) is written as the equation (15) using the equation (14).

$$s_\lambda(x_1, x_2, \ldots, x_n) = s_{(d_1, d_2, \ldots, d_n)}(x_1, x_2, \ldots, x_n)$$

$$= \frac{a_{(d_1+n-1, d_2+n-2, \ldots, d_n+0)}(x_1, x_2, \ldots, x_n)}{a_{(n-1, n-2, \ldots, 0)}(x_1, x_2, \ldots, x_n)} \quad (15)$$

For example, the Schur polynomials corresponding to partitions A = (2, 1) and $\lambda$ = (1, 1, 1) are written as the equations (16) and (17), respectively.

$$s_{(2,1)}(x_1, x_2, x_3)$$
$$= x_1^2 x_2 + x_1 x_2^2 + x_1^2 x_3 + x_1 x_3^2 + x_2^2 x_3 + x_2 x_3^2 + 2x_1 x_2 x_3 \quad (16)$$

$$s_{(1,1,1)}(x_1, x_2, x_3) = x_1 x_2 x_3 \quad (17)$$

(6) Jack Symmetric Polynomials

The Jack symmetric polynomial $J_\lambda^{(\alpha)}(x_1, x_2, \ldots, x_m)$ in variables $x_1, x_2, \ldots, x_m$ for a partition $\lambda$ and a parameter $\alpha$ is as follows.
In the case of m = 1, the Jack symmetric polynomial $J_\lambda^{(\alpha)}$ is written as the equation (18).

$$J_k^{(\alpha)}(x_1) = x_1^k (1 + \alpha) \ldots (1 + (k-1)) \quad (18)$$

In the case of m > 1, the Jack symmetric polynomial $J_\lambda^{(\alpha)}$ is written as the equation (19).

$$J_\lambda^{(\alpha)}(x_1, x_2, \ldots, x_m) = \sum_\mu J_\mu^{(\alpha)}(x_1, x_2, \ldots, x_{m-1}) x_m^{|\lambda/\mu|} \beta_{\lambda\mu} \quad (19)$$

The sum symbol $\Sigma$ with symbol $\mu$ in the equation (19) means a summation ranging over all partitions $\mu$. The partitions $\mu$ are that a skew partition $\lambda/\mu$ (represented as a skew Young diagram) is a horizontal strip, and satisfy the condition (20).

$$\lambda_1 \geq \mu_1 \geq \lambda_2 \geq \mu_2 \geq \cdots \geq \lambda_{n-1} \geq \mu_{n-1} \geq \lambda_n \quad (20)$$

Note that $\mu_n$ = 0; otherwise $J_\mu(x_1, \ldots, x_{n-1})$ = 0. A lower-right subscript such as a partition $\lambda$ of a symbol indicates the integer elements of the partition. In addition, the notation $\beta_{\lambda\mu}$ in the equation (19) is defined by the equations (21) and (22).

$$\beta_{\lambda\mu} = \frac{\prod_{(i,j) \in \lambda} B_{\lambda\mu}^\lambda(i,j)}{\prod_{(i,j) \in \mu} B_{\lambda\mu}^\mu(i,j)} \quad (21)$$

$$B_{\lambda\mu}^\nu = \begin{cases} \lambda_j' - i + \alpha(\lambda_i - j + 1) & (\lambda_j' = \mu_j') \\ \lambda_j' - i + 1 + \alpha(\lambda_i - j) & (\lambda_j' \neq \mu_j') \end{cases} \quad (22)$$

Partitions λ' and μ' in B are conjugate partitions to partitions λ and μ, respectively. In addition, the notation (i, j) ∈ λ in the product symbol n of the equation (21) means that the product is taken over the coordinates (i, j) (indicating the position of i-th row and j-th column) of all boxes included in the Young diagram of the partition λ.

With respect to the Young diagram of two partitions λ and μ satisfying μ ⊂ λ, a subset of NxN (where N is the set of all natural numbers) defined as the set difference λ\μ is called a skew Young diagram and is denoted by λ/μ. Assume that |λ/μ| = |λ| - |μ|. A skew Young diagram that includes only one box in every column is called a horizontal strip. A skew Young diagram that includes only one box in every row is called a vertical strip.

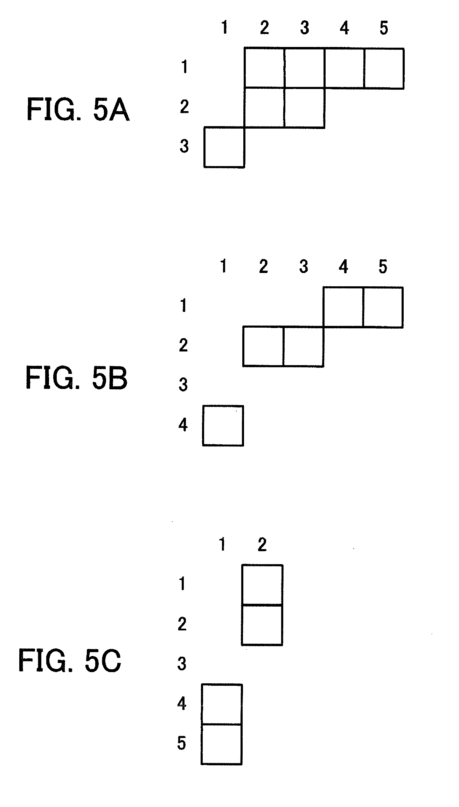

FIGS. 5A, 5B, and 5C are exemplary skew Young diagrams. FIG. 5A exemplifies a skew Young diagram that is neither a horizontal strip nor a vertical strip. In FIG. 5A, λ = (5, 3, 1) and μ = (1, 1). In this connection, for easy understanding on rows (the horizontal direction of the paper) and columns (the vertical direction of the paper), row numbers and column numbers are given in FIGS. 5A, 5B, and 5C.

FIG. 5B exemplifies a horizontal strip. In FIG. 5B, λ = (5, 3, 1, 1) and μ = (3, 1, 1). FIG. 5C exemplifies a vertical strip. In FIG. 5C, λ = (2, 2, 1, 1, 1) and μ = (1, 1, 1).

For example, the Jack symmetric polynomials corresponding to partitions λ = (2, 1) and λ = (1, 1, 1) are written as the expressions (23) and (24), respectively.

$$
J_{(2,1)}^{(\alpha)}(x_1, x_2, x_3)
$$

$$
= x_1^2 x_2 + x_1 x_2^2 + x_1^2 x_3 + x_1 x_3^2 + x_2^2 x_3 + x_2 x_3^2 + \frac{6}{\alpha + 2} x_1 x_2 x_3 \quad (23)
$$

$$
J_{(1,1,1)}^{(\alpha)}(x_1, x_2, x_3) = x_1 x_2 x_3 \quad (24)
$$

(7) Hall-Littlewood symmetric polynomials

A Hall-Littlewood symmetric polynomial in variables $x_1$, $x_2$, ..., $x_n$ for a partition λ and a parameter t is written as the equation (25), where the symbol m(i) denotes the number of elements in λ that are equal to i and the symbol Sn denotes a symmetric group of order n!.

$$
P_\lambda(x_1, \ldots, x_n; t) = \prod_i \frac{1-t}{1-t^{m(i)}} \sum_{w \in S_n} w\left( x_1^{\lambda_1} \ldots x_n^{\lambda_n} \prod_{i<j} \frac{x_i - t x_j}{x_i - x_j} \right) \quad (25)
$$

For example, the Hall-Littlewood symmetric polynomials corresponding to partitions A = (2, 1) and λ = (1, 1, 1) are written as the equations (26) and (27), respectively.

$$
P_{(2,1)}^{(t)}(x_1, x_2, x_3) = x_1^2 x_2 + x_1 x_2^2 + x_1^2 x_3 + x_1 x_3^2 + x_2^2 x_3 + x_2 x_3^2
$$

$$
+(-t^2 - t + 2)x_1 x_2 x_3 \quad (26)
$$

$$
P_{(1,1,1)}^{(t)}(x_1, x_2, x_3) = x_1 x_2 x_3 \quad (27)
$$

(8) Macdonald symmetric polynomials

An-type Macdonald symmetric polynomials (hereinafter, referred to as Macdonald symmetric polynomials, simply) are used. The Macdonald symmetric polynomials include parameters t and q. For example, the Macdonald symmetric polynomials corresponding to partitions λ = (2, 1) and λ = (1, 1, 1) are written as the equations (28) and (29), respectively.

$$P_{(2,1)}^{(t,q)}(x_1, x_2, x_3) = x_1^2 x_2 + x_1 x_2^2 + x_1^2 x_3 + x_1 x_3^2 + x_2^2 x_3 + x_2 x_3^2$$
$$+ \frac{-2qt^2 + qt - t^2 + q - t + 2}{-qt^2 + 1} x_1 x_2 x_3 \qquad (28)$$

$$P_{(1,1,1)}^{(t,q)}(x_1, x_2, x_3) = x_1 x_2 x_3 \qquad (29)$$

The above description exemplifies symmetric polynomials of some degrees. However, symmetric polynomials of other degrees may be applicable. Further, the above description exemplifies some kinds of symmetric polynomials in three variables as simple examples. However, symmetric polynomials in four or more variables may be applicable. Still further, the above description exemplifies some kinds of symmetric polynomials that are usable for calculating feature values. However, other kinds of symmetric polynomials may be used.

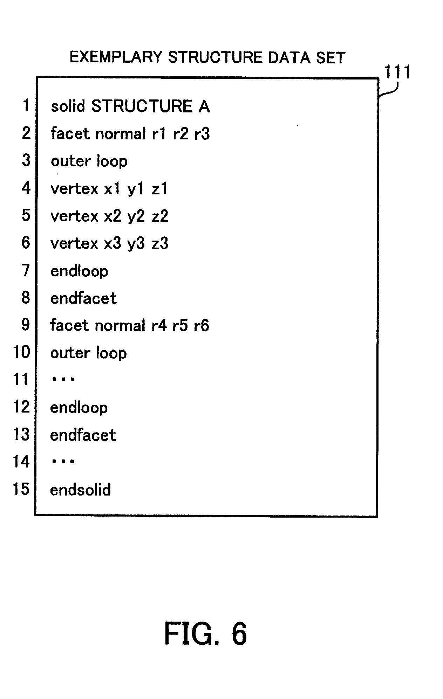

FIG. 6 illustrates an exemplary structure data set. The structure data set 111 has the following format. Note that row numbers are given on the left side of the structure data set 111. The identification information (for example, "structure A") of a structure is set after a character string "solid" (first row).

The components of a normal vector are set after a character string "facet normal" (second row). Rows from the "facet normal" row (second row) to the "endfacet" row (eighth row) correspond to information on one polygon. The coordinates of the vertices of the polygon is set after a character string "vertex". Since triangle polygons are considered here, the coordinates of three vertices are set using the character string "vertex" with respect to each polygon.

In addition, the normal vector indicated in the structure data set 111 distinguishes the front and back of the polygon from each other. The order of setting the coordinates of the vertices of the polygon also distinguishes the front and back of the polygon from each other. The other polygons are defined in the ninth and subsequent rows in the same way. A character string "endsolid" is set at the last row of the structure data set 111 (15th row).

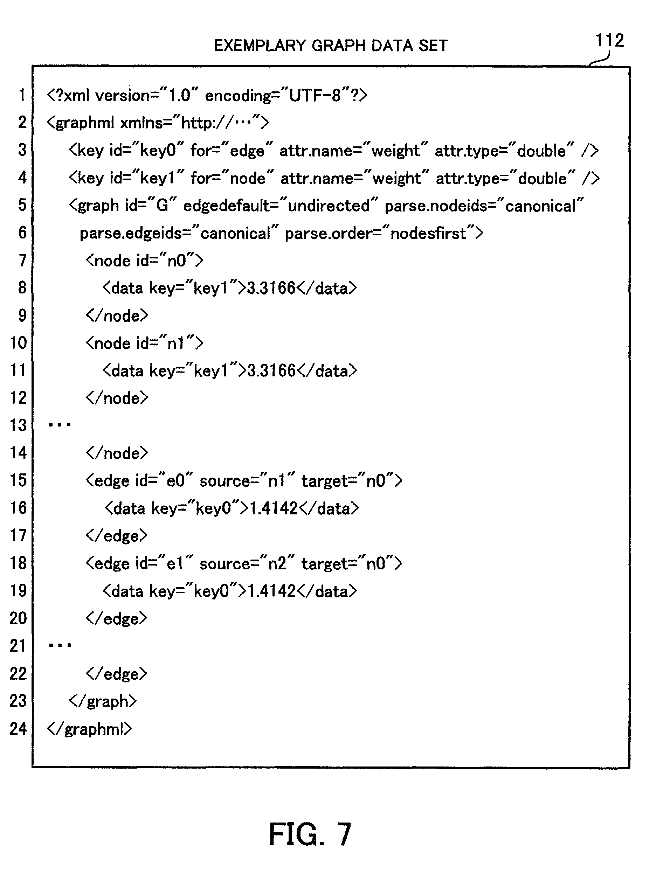

FIG. 7 illustrates an exemplary graph data set. Assume now that the graph data set 112 is in GraphML format. GraphML uses eXtensible Markup Language (XML) to describe nodes and edges. Another format may be used. This example uses an undirected graph. However, a directed graph may be used. Row numbers are given on the left side of the graph data set 112.

For example, the third row defines a key "key0" for an edge. With a tag of key id "key0", an attribute corresponding to the weight of the edge is given to the edge. The length of the side corresponding to an edge is used to represent the weight of the edge.

The fourth row defines a key "key1" for a node. With a tag of key id "key1", an attribute corresponding to the weight of the node is given to the node. A distance between the vertex corresponding to a node and the center of gravity of the structure is used to represent the weight of the node.

For example, the graph data set 112 defines the weight "3.3166" for the node with node ID "n0" (7th to 9th rows). The node with node ID "n1" (10th to 12th rows) and the other nodes are defined in the same way.

In addition, the graph data set 112 defines that the edge with edge ID "e0" connects the node with node ID "n1" and the node with node ID "n0" and the weight of the edge is "1.4142" (15th to 17th rows). The edge with edge ID "e1" (18th to 20th rows) and the other edges are defined in the same way. Note that the weights of nodes and edges are expressed as a vector and a matrix. As a simple example, a tetrahedron will be considered.

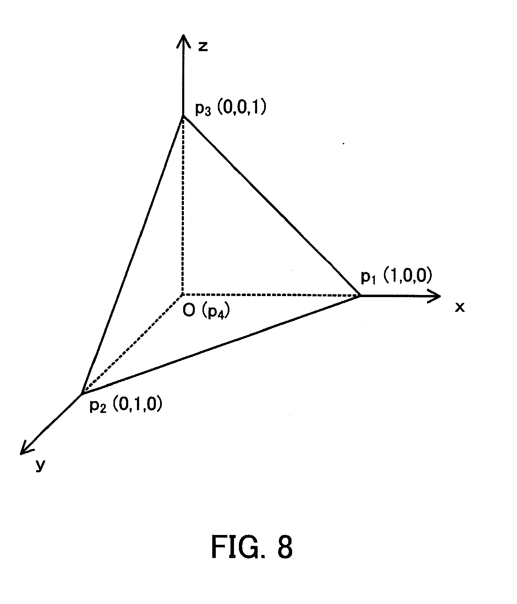

FIG. 8 illustrates an exemplary tetrahedron. The illustrated tetrahedron has vertices $p_1$, $p_2$, $p_3$, and $p_4$ in the orthogonal coordinate system (using x-, y-, and z-axes). The vertex $p_1$ has the coordinates (1, 0, 0). The vertex $p_2$ has the coordinates (0, 1, 0). The vertex $p_3$ has the coordinates (0, 0, 1). The vertex $p_4$ is at the original point O. This tetrahedron is formed by, for example, four polygons, i.e., a triangle $p_1$, $p_2$, and $p_3$, a triangle $p_2$, $p_3$, and $p_4$, a triangle $p_3$, $p_4$, and $p_1$, and a triangle $p_4$, $p_1$, and $p_2$.

For example, assuming that the distance between the center of gravity and a vertex of a tetrahedron represents the weight of the vertex (or a node corresponding to the vertex in the graph), the vertex weight vector X is written as the equation (30).

$$\mathbf{X} = \begin{pmatrix} \dfrac{\sqrt{11}}{4} \\[2mm] \dfrac{\sqrt{11}}{4} \\[2mm] \dfrac{\sqrt{11}}{4} \\[2mm] \dfrac{\sqrt{3}}{4} \end{pmatrix} \qquad (30)$$

In addition, assuming the length of a side of the tetrahedron represents the weight of the side (or an edge corresponding to the side in the graph), the side weight matrix W is written as the equation (31).

$$\mathbf{W} = \begin{matrix} & \begin{matrix} p_1 & p_2 & p_3 & p_4 \end{matrix} \\ \begin{matrix} p_1 \\ p_2 \\ p_3 \\ p_4 \end{matrix} & \begin{pmatrix} 0 & \sqrt{2} & \sqrt{2} & 1 \\ \sqrt{2} & 0 & \sqrt{2} & 1 \\ \sqrt{2} & \sqrt{2} & 0 & 1 \\ 1 & 1 & 1 & 0 \end{pmatrix} \end{matrix} \qquad (31)$$

In this connection, the i-th row and j-th column element corresponds to the length of a side connecting the vertices $p_i$ and $p_j$. Since a side is not formed by a single vertex, the diagonal elements are "0".

The weights of nodes and edges in a graph are expressed as the vector X and matrix W in this way. The feature value calculation unit 140 generates a vector reflecting these weights, and applies the elements of the vector to the variables in symmetric polynomials. More specifically, the feature value calculation unit 140 generates the matrix D(X) defined by the equation (3). The matrix D(X) for the vector X of the equation (30) is written as the equation (32).

$$\mathbf{D(X)} = \begin{pmatrix} \dfrac{\sqrt{11}}{4} & 0 & 0 & 0 \\[2mm] 0 & \dfrac{\sqrt{11}}{4} & 0 & 0 \\[2mm] 0 & 0 & \dfrac{\sqrt{11}}{4} & 0 \\[2mm] 0 & 0 & 0 & \dfrac{\sqrt{3}}{4} \end{pmatrix} \qquad (32)$$

Then, the feature value calculation unit 140 generates a matrix $M^l$ defined by the equation (4). For example, in the case of l = 1, the matrix $M^l = M = D(X)WD(X)$ is written as the equation (33).

$$\mathbf{D(X)WD(X)} = \begin{pmatrix} 0 & 0.9723 & 0.9723 & 0.3590 \\ 0.9723 & 0 & 0.9723 & 0.3590 \\ 0.9723 & 0.9723 & 0 & 0.3590 \\ 0.3590 & 0.3590 & 0.3590 & 0 \end{pmatrix} \tag{33}$$

The i-th row and j-th column element of the matrix $M^l$ is defined by the equation (34).

$$M_{ij}^l = \left( D(X)(WD(X))^l \right)_{ij} \tag{34}$$

For example, to transform the matrix $M^l$ into a vector with N (N is the number of vertices (nodes)) elements, the following $sum_R$ operation (formula (35)), $sum_C$ operation (formula (36)), and diag operation (formula (37)) are considered.

$$sum_R \; : \; M_{ij}^l \mapsto \sum_j M_{ij}^l \tag{35}$$

$$sum_C \; : \; M_{ij}^l \mapsto \sum_i M_{ij}^l \tag{36}$$

$$diag \; : \; M_{ij}^l \mapsto M_{ii}^l \tag{37}$$

The $sum_R$ operation is to calculate the sum for each column of the matrix $M^l$. The $sum_C$ operation is to calculate the sum for each row of the matrix $M^l$. The diag operation is to extract the diagonal elements from the matrix $M^l$.

In addition, to generate a 1st-oder tensor from a 2nd-order tensor, methods other than these $sum_R$, $sum_C$, and diag operations are considered. For example, a symmetric polynomial $f_j$ in n variables is written as the equation (38).

$$f_j = f(M_{1j}^l, M_{2j}^l, \ldots, M_{Nj}^l) \tag{38}$$

This equation uses a fixed column number j and the row numbers i of the matrix $M^l$. With respect to the symmetric polynomial $f_j$, the same kind or a different kind of symmetric polynomial g is considered, which is written as the equation (39).

$$\begin{aligned} g = g\big( & f(M_{11}^l, M_{21}^l, \ldots, M_{N1}^l), \\ & f(M_{12}^l, M_{22}^l, \ldots, M_{N2}^l), \ldots, \\ & f(M_{1N}^l, M_{2N}^l, \ldots, M_{NN}^l) \big) \end{aligned} \tag{39}$$

A calculation result of the symmetric polynomial g is also symmetric group invariant. That is to say, a vector $(f_1, f_2, \ldots, f_n)$ may be generated with the matrix $M^l$ and symmetric polynomial $f_j$. Alternatively, it is also considered that, a vector having, as elements, the values calculated with the symmetric polynomial $f_i$ (i = 1, 2, ..., n) using a fixed row number i and the column numbers j of the matrix $M^l$.

The computing apparatus 100 uses these operations for calculating feature values with symmetric polynomials in the following manner. First, a procedure for determining a degree and parameters to be used in the operation of symmetric polynomials will be exemplified.

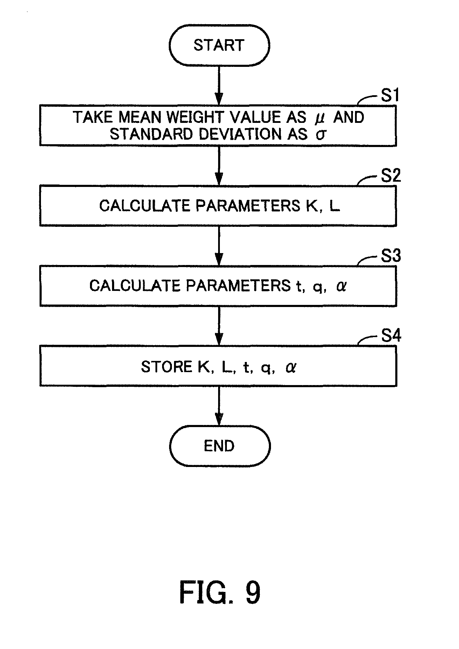

FIG. 9 is a flowchart illustrating an example of how to determine a degree and parameters. The process of FIG. 9 will be described step by step.

(S1) The parameter setting unit 130 calculates a mean weight value $\mu$ and a standard deviation $\sigma$ with respect to nodes and edges on the basis of all graph data sets stored in the storage unit 110.

(S2) The parameter setting unit 130 calculates parameters K and L. More specifically, the parameters K and L are written as the equation (40).

$$L = K = \left[ \sqrt{\frac{1000\mu}{\sigma}} \right] \propto \left( \frac{\sigma}{\mu} \right)^{-\frac{1}{2}} \qquad (40)$$

The square brackets ("[]") in the equation (40) are Gauss symbols (that is, the value is truncated to the nearest integer). Alternatively, K and L may be rounded off or out to the nearest integer. As is be seen from the equation (40), when a relative error ($\sigma/\mu$) is greater, smaller parameters K and L are calculated. As will be described later, the parameter K corresponds to the degree (the maximum degree to be used in calculating feature values) of a symmetric polynomial for calculating feature values.

(S3) The parameter setting unit 130 calculates parameters t, q, and $\alpha$. More specifically, the parameters t and $\alpha$ are calculated with the equation (41), and the parameter q is calculated with the equation (42).

$$t = \alpha = \frac{\mu}{\sigma} \qquad (41)$$

$$q = \exp\left( \frac{\mu}{\sigma} \right) \qquad (42)$$

(S4) The parameter setting unit 130 stores the determined parameters K, L, t, q, and $\alpha$ in the storage unit 110.

As described above, the computing apparatus 100 determines a degree and parameters to be used in the operation of a symmetric polynomial on the basis of the distribution of the weights included in the graph data sets. In this connection, at step S1, statistical values such as a mean value $\mu$ and standard deviation $\sigma$ with respect to weights may be calculated from some of the graph data sets (in the library) stored in the storage unit 110. For example, such statistical values may be calculated by sampling a predetermined number of graph data sets.

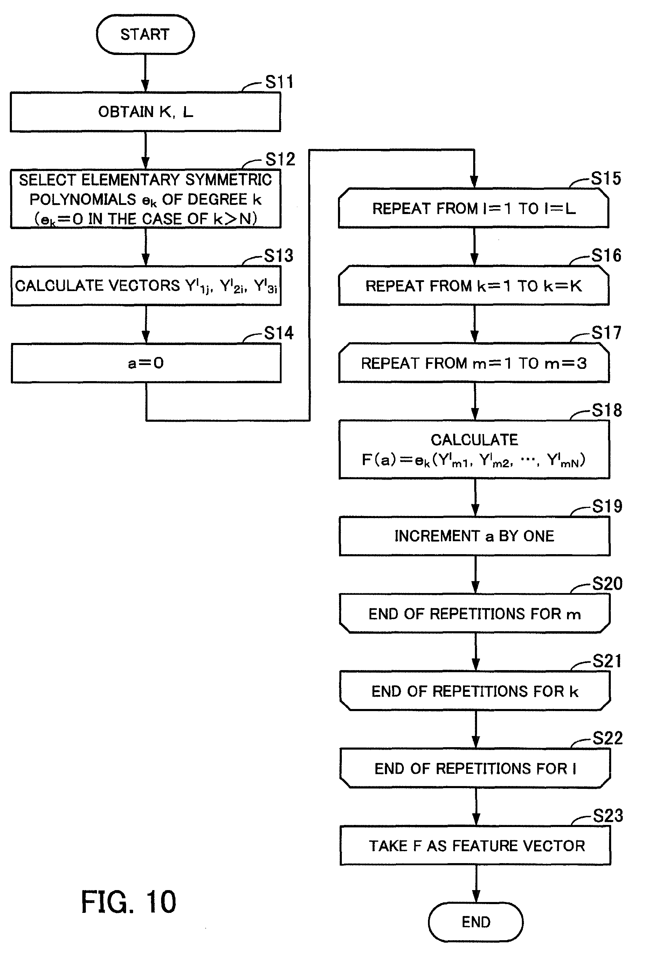

If structure data sets are classified into some categories (for example, mechanical components, electronic components, and others), a degree and parameters may be calculated for each category. In this case, using the degree and parameters of the category to which a structure data set belongs, the computing apparatus 100 calculates the feature values of the structure data set through the procedures described in FIG. 10 and subsequent figures.

Yet alternatively, for each structure data set (each graph data set) for which feature values are to be calculated, the computing apparatus 100 may determine the parameters from the graph data set corresponding to the structure data set. For example, for each structure data set for which feature values are to be calculated, the computing apparatus 100 may determine its dedicated degree and parameters on the basis of only the graph data set corresponding to the structure data set. Then, the computing apparatus 100 may use the degree and parameters for each structure data set to calculate the feature values of the structure data set through the procedures described in FIG. 10 and subsequent figures.

For example, there is an option of selecting which of the above items to use, all graph data sets in the library, categories, or a structure data set (graph data set), to determine parameters (including a degree), according to actual operation (operation test). This makes it possible to select a method that improves the accuracy of structure data search.

Further, at step S1, the computing apparatus 100 obtains a relative error with respect to both nodes and edges. Alternatively, the computing apparatus 100 may obtain a relative error with respect to either nodes or edges. In addition, the computing apparatus 100 may calculate only parameters needed for symmetric polynomials to be used in calculating feature values (for example, the parameter $\alpha$ may not be calculated in the case where Jack symmetric polynomials are not used). Then, the computing apparatus 100 calculates a feature vector using the determined parameters through any of the following procedures. In the following description, a symbol N denotes the number of nodes.

FIG. 10 is a flowchart illustrating a first example of how to calculate a feature vector. The process of FIG. 10 will be described step by step.

(Step S11) The feature value calculation unit 140 obtains a graph data set for which a feature vector is to be calculated and the parameters K and L determined by the parameter setting unit 130.

(S12) The feature value calculation unit 140 selects the elementary symmetric polynomials $e_k$ of degree k, where the symbol k is an integer satisfying $1 \leq k \leq K$. In this connection, $e_k = 0$ in the case of $k > N$.

(S13) The feature value calculation unit 140 calculates vectors $Y^l_{1j}$, $Y^l_{2i}$, $Y^l_{3i}$ with the $sum_C$ operation (formula (36)), $sum_R$ operation (formula (35)), and diag operation (formula (37)), respectively, where the symbol 1 is an integer satisfying $1 \leq 1 \leq L$. The vectors $Y^l_{1j}$, $Y^l_{2i}$, $Y^l_{3i}$ are written as the equations (43), (44), and (45).

$$Y^l_{1j} = \sum_i \left( D(X)(WD(X))^l \right)_{ij} \qquad (43)$$

$$Y^l_{2i} = \sum_j \left( D(X)(WD(X))^l \right)_{ij} \qquad (44)$$

$$Y^l_{3i} = \left( D(X)(WD(X))^l \right)_{ii} \qquad (45)$$

(S14) The feature value calculation unit 140 substitutes zero for the variable a.

(S15) The feature value calculation unit 140 substitutes 1 to L for 1 in order, and executes steps S16 to S21 for each substitution.

(S16) The feature value calculation unit 140 substitutes 1 to K for k in order, and executes steps S17 to S20 for each substitution.

(S17) The feature value calculation unit 140 substitutes 1, 2, and 3 for m in order, and executes steps S18 and S19 for each substitution.

(S18) The feature value calculation unit 140 calculates $F(a) = e_k(Y^l)$ defined by the equation (46).

$$e_k(Y^l) = e_k(Y^l_{m1}, Y^l_{m2}, \ldots, Y^l_{mN}) \qquad (46)$$

(S19) The feature value calculation unit 140 increments the variable a by one.

(S20) When the calculation up to m = 3 is complete, the process proceeds to step S21. Otherwise, the process proceeds back to step S17.

(S21) When the calculation up to k = K is complete, the process proceeds to step S22. Otherwise, the process proceeds back to step S16.

(S22) When the calculation up to l = L is complete, the process proceeds to step S23. Otherwise, the process proceeds back to step S15.

(S23) The feature value calculation unit 140 takes F = (F(0), F(1), ..., F(3KL)) as a feature vector for the graph data set obtained at step S11. The feature value calculation unit 140 identifies the structure data set corresponding to the graph data set, and then stores the calculated feature vector in association with the identified structure data set in the storage unit 110.

As described above, the computing apparatus 100 calculates feature values and a feature vector with the elementary symmetric polynomials. For example, the computing apparatus 100 may use complete symmetric polynomials or Newton symmetric polynomials, in place of the elementary symmetric polynomials, in the same procedure as described in FIG. 10.

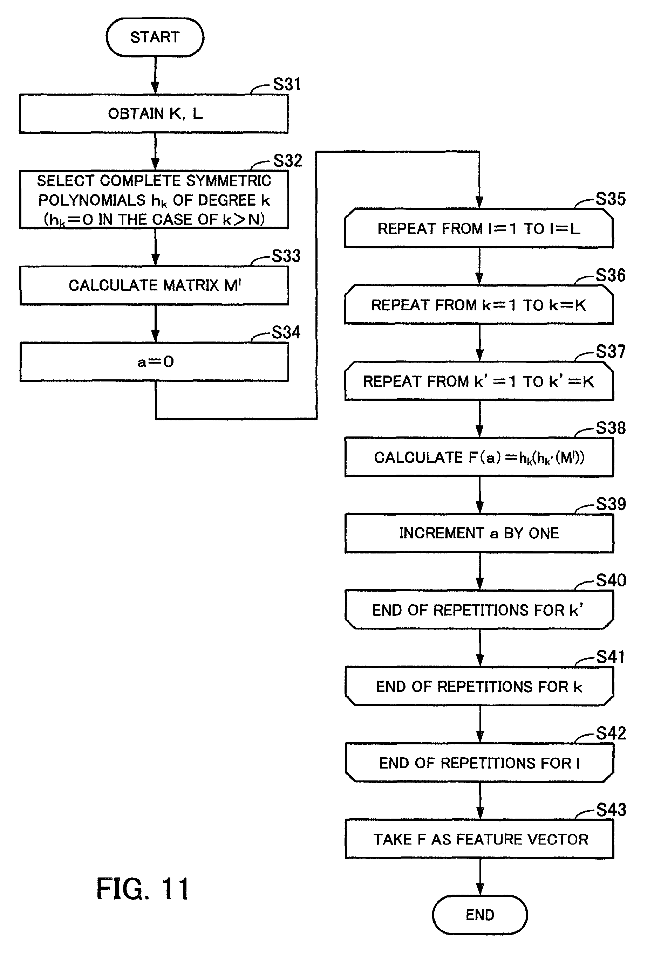

FIG. 11 is a flowchart illustrating a second example of how to calculate a feature vector. The process of FIG. 11 will be described step by step.

(S31) The feature value calculation unit 140 obtains a graph data set for which a feature vector is to be calculated and the parameters K and L determined by the parameter setting unit 130.

(S32) The feature value calculation unit 140 selects the complete symmetric polynomials $h_k$ of degree k, where the symbol k is an integer satisfying $1 \leq k \leq K$. In this connection, $h_k = 0$ in the case of $k > N$.

(S33) The feature value calculation unit 140 calculates the matrix $M^l$ with the equation (4).

(S34) The feature value calculation unit 40 substitutes zero for the variable a.

(S35) The feature value calculation unit 140 substitutes 1 to L for 1 in order, and executes steps S36 to S41 for each substitution.

(S36) The feature value calculation unit 140 substitutes 1 to K for k in order, and executes steps S37 to S40 for each substitution.

(S37) The feature value calculation unit 140 substitutes 1 to K for k' in order, and executes steps S38 and S39 for each substitution.

(S38) The feature value calculation unit 140 calculates F(a) = $h_k(h_{k'}(M^l))$ defined by the equation (47).

$$h_k\left(h_{k'}(M^l)\right) = h_k\left(h_{k'}(M^l_{11}, M^l_{21}, \ldots, M^l_{N1}), \\ h_{k'}(M^l_{12}, M^l_{22}, \ldots, M^l_{N2}), \ldots, \\ h_{k'}(M^l_{1N}, M^l_{2N}, \ldots, M^l_{NN})\right) \qquad (47)$$

(S39) The feature value calculation unit 140 increments the variable a by one.

(S40) When the calculation up to k' = K is complete, the process proceeds to step S41. Otherwise, the process proceeds back to step S37.

(S41) When the calculation up to k = K is complete, the process proceeds to step S42. Otherwise, the process proceeds back to step S36.

(S42) When the calculation up to l = L is complete, the process proceeds to step S43. Otherwise, the process proceeds back to step S35.

(S43) The feature value calculation unit 140 takes F = (F(0), F(1), ..., F($K^2L$)) as a feature vector for the graph data set obtained at step S31. The feature value calculation unit 140 identifies the structure data set corresponding to the graph data set, and then stores the calculated feature vector in association with the identified structure data set in the storage unit 110.

As described above, the calculation unit 110 may use symmetric polynomials to transform a 2nd-order tensor (i.e., a matrix) into a 1st-order tensor (i.e., a vector) and may calculate feature values by substituting the elements of the 1st-order tensor for the variables of the same kind of symmetric polynomials. Thus calculated feature values appropriately reflect the weights included in a graph.

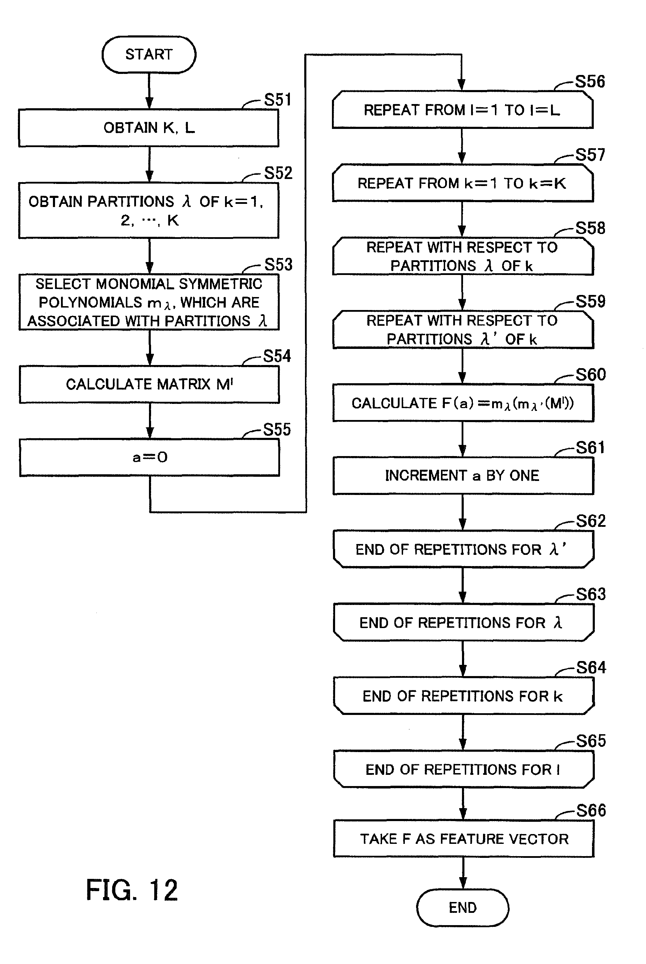

FIG. 12 is a flowchart illustrating a third example of how to calculate a feature vector. The process of FIG. 12 will be described step by step.

(S51) The feature value calculation unit 140 obtains a graph data set for which a feature vector is to be calculated and the parameters K and L determined by the parameter setting unit 130.

(S52) The feature value calculation unit 140 obtains partitions λ of k (k is an integer satisfying 1 ≤ k ≤ K). That is, the feature value calculation unit 140 obtains a plurality of partitions λ for each integer k = 1, 2, ..., K.

(S53) The feature value calculation unit 140 selects the monomial symmetric polynomials $m_λ$, which are associated with the partitions λ obtained at step S52.

(S54) The feature value calculation unit 140 calculates the matrix $M^l$ with the equation (4).

(S55) The feature value calculation unit 40 substitutes zero for the variable a.

(S56) The feature value calculation unit 140 substitutes 1 to L for 1 in order, and executes steps S57 to S64 for each substitution.

(S57) The feature value calculation unit 140 substitutes 1 to K for k in order, and executes steps S58 to S63 for each substitution.

(S58) The feature value calculation unit 140 executes steps S59 to S62 for each of all the partitions λ with respect to the current k.

(S59) The feature value calculation unit 140 executes steps S60 and S61 for each of all the partitions λ' with respect to the current k.

(S60) The feature value calculation unit 140 calculates F(a) = $m_λ(m_{λ'}(M^l))$ defined by the equation (48).

$$m_λ\left(m_{λ'}(M^l)\right) = m_λ\left(m_{λ'}(M^l_{11}, M^l_{21}, \ldots, M^l_{N1}), \\ m_{λ'}(M^l_{12}, M^l_{22}, \ldots, M^l_{N2}), \ldots, \\ m_{λ'}(M^l_{1N}, M^l_{2N}, \ldots, M^l_{NN})\right) \qquad (48)$$

(S61) The feature value calculation unit 140 increments the variable a by one.

(S62) When the calculation for all of the partitions λ' with respect to the current k is complete, the process proceeds to step S63. Otherwise, the process proceeds back to step S59.

(S63) When the calculation for all of the partitions λ with respect to the current k is complete, the process proceeds to step S64. Otherwise, the process proceeds back to step S58.

(S64) When the calculation up to k = K is complete, the process proceeds to step S65. Otherwise, the process proceeds back to step S57.

(S65) When the calculation up to l = L is complete, the process proceeds to step S66. Otherwise, the process proceeds back to step S56.

(S66) The feature value calculation unit 140 takes F = (F(0), F(1), ...) as a feature vector for the graph data set obtained at step S51. The feature value calculation unit 140 identifies a structure data set corresponding to the graph data set, and then stores the calculated feature vector in association with the identified structure data set in the storage unit 110.

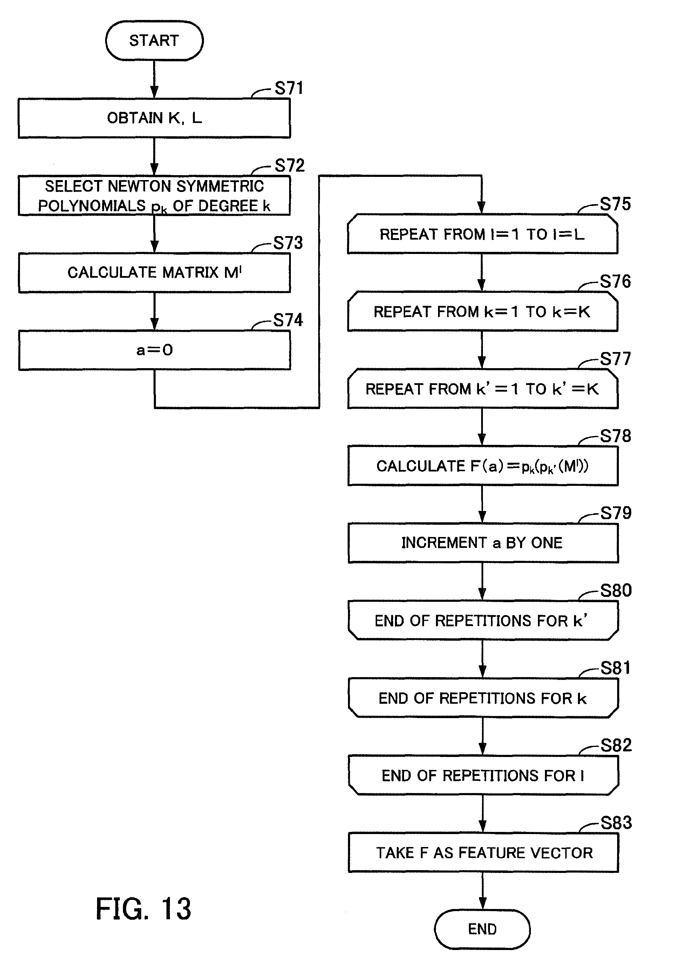

FIG. 13 is a flowchart illustrating a fourth example of how to calculate a feature vector. The process of FIG. 13 will be described step by step.

(S71) The feature value calculation unit 140 obtains a graph data set for which a feature vector is to be calculated and the parameters K and L determined by the parameter setting unit 130.

(S72) The feature value calculation unit 140 selects the Newton symmetric polynomials $p_k$ of degree k, where the symbol k is an integer satisfying $1 \leq k \leq K$.

(S73) The feature value calculation unit 140 calculates the matrix $M^l$ with the equation (4).

(S74) The feature value calculation unit 40 substitutes zero for the variable a.

(S75) The feature value calculation unit 140 substitutes 1 to L for 1 in order, and executes steps S76 to S81 for each substitution.

(S76) The feature value calculation unit 140 substitutes 1 to K for k in order, and executes steps S77 to S80 for each substitution.

(S77) The feature value calculation unit 140 substitutes 1 to K for k' in order, and executes steps S78 and S79 for each substitution.

(S78) The feature value calculation unit 140 calculates F(a) = $p_k(p_{k'}(M^l))$ defined by the equation (49).

$$p_k\left(p_{k'}(M^l)\right) = p_k\left(p_{k'}(M^l_{11}, M^l_{21}, \ldots, M^l_{N1}),\right.$$
$$p_{k'}(M^l_{12}, M^l_{22}, \ldots, M^l_{N2}), \ldots,$$
$$\left.p_{k'}(M^l_{1N}, M^l_{2N}, \ldots, M^l_{NN})\right) \qquad (49)$$

(S79) The feature value calculation unit 140 increments the variable a by one.

(S80) When the calculation up to k' = K is complete, the process proceeds to step S81. Otherwise, the process proceeds back to step S77.

(S81) When the calculation up to k = K is complete, the process proceeds to step S82. Otherwise, the process proceeds back to step S76.

(S82) When the calculation up to l = L is complete, the process proceeds to step S83. Otherwise, the process proceeds back to step S75.

(S83) The feature value calculation unit 140 takes F = (F(0), F(1), ..., F($K^2$L)) as a feature vector for the graph data set obtained at step S71. The feature value calculation unit 140 identifies a structure data set corresponding to the graph data set, and then stores the calculated feature vector in association with the identified structure data set in the storage unit 110.

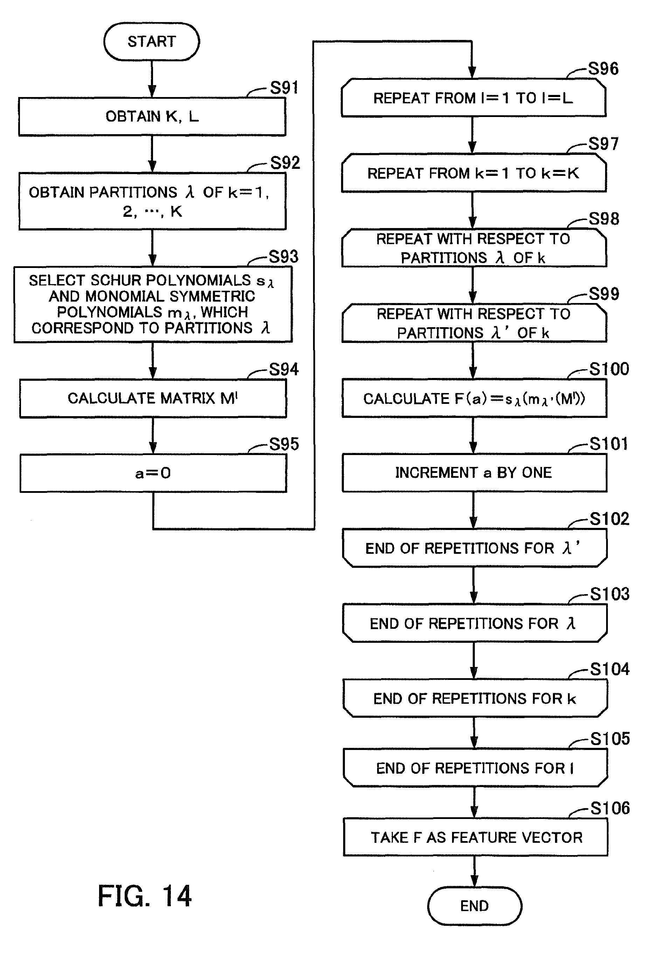

FIG. 14 is a flowchart illustrating a fifth example of how to calculate a feature vector. The process of FIG. 14 will be described step by step.

(S91) The feature value calculation unit 140 obtains a graph data set for which a feature vector is to be calculated and the parameters K and L determined by the parameter setting unit 130.

(S92) The feature value calculation unit 140 obtains partitions λ of k (k is an integer satisfying $1 \leq k \leq K$). That is, the feature value calculation unit 140 obtains a plurality of partitions A for each integer k = 1, 2, ..., K.

(S93) The feature value calculation unit 140 selects the Schur polynomials $s_\lambda$ and monomial symmetric polynomials $m_\lambda$, which correspond to the partitions A obtained at step S92.

(S94) The feature value calculation unit 140 calculates the matrix $M^l$ with the equation (4).

(S95) The feature value calculation unit 40 substitutes zero for the variable a.

(S96) The feature value calculation unit 140 substitutes 1 to L for 1 in order, and executes steps S97 to S104 for each substitution.

(S97) The feature value calculation unit 140 substitutes 1 to K for k in order, and executes steps S98 to S103 for each substitution.

(S98) The feature value calculation unit 140 executes steps S99 to S102 for each of all the partitions $\lambda$ with respect to the current k.

(S99) The feature value calculation unit 140 executes steps S100 and S101 for each of all the partitions $\lambda$' with respect to the current k.

(S100) The feature value calculation unit 140 calculates F(a) = $s_\lambda\setminus(m_\lambda,(M^l))$ defined by the equation (50).

$$
\begin{aligned}
s_\lambda\left(m_{\lambda'}(M^l)\right) = s_\lambda\big(&m_{\lambda'}(M^l_{11}, M^l_{21}, \ldots, M^l_{N1}), \\
&m_{\lambda'}(M^l_{12}, M^l_{22}, \ldots, M^l_{N2}), \ldots, \\
&m_{\lambda'}(M^l_{1N}, M^l_{2N}, \ldots, M^l_{NN})\big)
\end{aligned}
\qquad (50)
$$

(S101) The feature value calculation unit 140 increments the variable a by one.

(S102) When the calculation for all the partitions $\lambda$' with respect to the current k is complete, the process proceeds to step S103. Otherwise, the process proceeds back to step S99.

(S103) When the calculation for all the partitions $\lambda$ with respect to the current k is complete, the process proceeds to step S104. Otherwise, the process proceeds back to step S98.

(S104) When the calculation up to k = K is complete, the process proceeds to step S105. Otherwise, the process proceeds back to step S97.

(S105) When the calculation up to l = L is complete, the process proceeds to step S106. Otherwise, the process proceeds back to step S96.

(S106) The feature value calculation unit 140 takes F = (F(0), F(1), ...) as a feature vector for the graph data set obtained at step S91. The feature value calculation unit 140 identifies a structure data set corresponding to the graph data set, and then stores the calculated feature vector in association with the identified structure data set in the storage unit 110.

As described above, the computing apparatus 100 may use symmetric polynomials (a first kind of symmetric polynomials) to transform a 2nd-order tensor into a 1st-order tensor, and may calculate feature values by substituting the result into another kind of symmetric polynomials (a second kind of symmetric polynomials). Thus calculated feature values appropriately reflect the weights included in a graph.

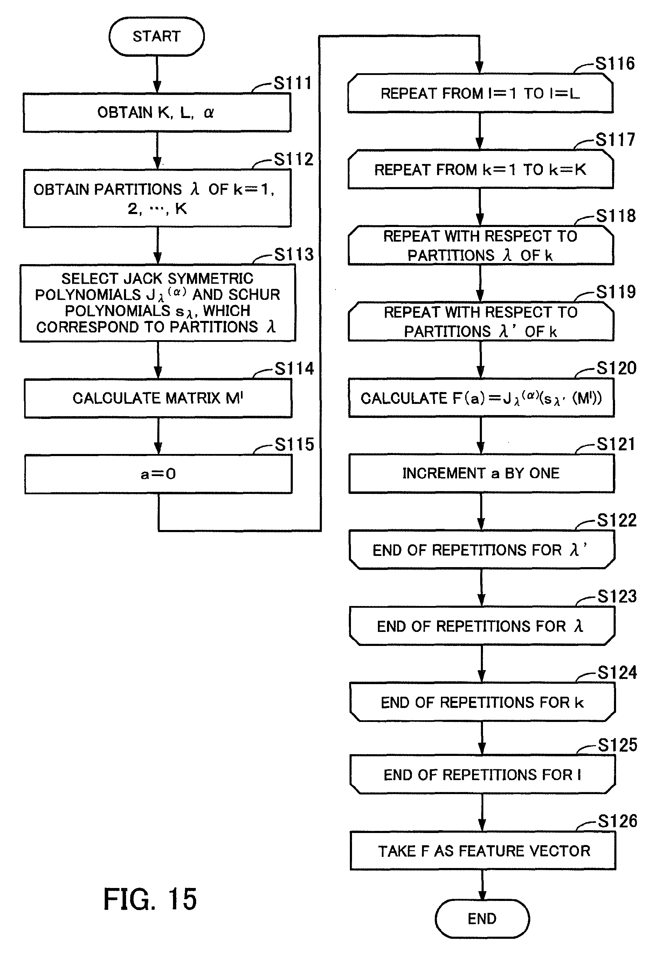

FIG. 15 is a flowchart illustrating a sixth example of how to calculate a feature vector. The process of FIG. 15 will be described step by step.

(S111) The feature value calculation unit 140 obtains a graph data set for which a feature vector is to be calculated and the parameters K, L, and $\alpha$ determined by the parameter setting unit 130.

(S112) The feature value calculation unit 140 obtains partitions $\lambda$ of k (k is an integer satisfying $1 \le k \le K$). That is, the feature value calculation unit 140 obtains a plurality of partitions $\lambda$ for each integer k = 1, 2, ..., K.

(S113) The feature value calculation unit 140 selects the Jack symmetric polynomials $J_\lambda^{(\alpha)}$ and Schur polynomials $s_\lambda$, which correspond to the partitions A obtained at step S112.

(S114) The feature value calculation unit 140 calculates the matrix $M^l$ with the equation (4).

(S115) The feature value calculation unit 40 substitutes zero for the variable a.

(S116) The feature value calculation unit 140 substitutes 1 to L for 1 in order, and executes steps S117 to S124 for each substitution.

(S117) The feature value calculation unit 140 substitutes 1 to K for k in order, and executes steps S118 to S123 for each substitution.

(S118) The feature value calculation unit 140 executes steps S119 to S122 for each of all the partitions $\lambda$ with respect to the current k.

(S119) The feature value calculation unit 140 executes steps S120 and S121 for each of all the partitions A' with respect to the current k.

(S120) The feature value calculation unit 140 calculates F(a) = $J_\lambda^{(\alpha)}$ ($s_{\lambda'}$ ($M^l$)) defined by the equation (51).

$$J_\lambda^{(\alpha)}\big(s_{\lambda'}(M^l)\big) = J_\lambda^{(\alpha)}\big(s_{\lambda'}(M_{11}^l, M_{21}^l, \ldots, M_{N1}^l),$$
$$s_{\lambda'}(M_{12}^l, M_{22}^l, \ldots, M_{N2}^l), \ldots,$$
$$s_{\lambda'}(M_{1N}^l, M_{2N}^l, \ldots, M_{NN}^l)\big) \qquad (51)$$

(S121) The feature value calculation unit 140 increments the variable a by one.

(S122) When the calculation for all the partitions λ' with respect to the current k is complete, the process proceeds to step S123. Otherwise, the process proceeds back to step S119.

(S123) When the calculation for all the partitions λ with respect to the current k is complete, the process proceeds to step S124. Otherwise, the process proceeds back to step S118.

(S124) When the calculation up to k = K is complete, the process proceeds to step S125. Otherwise, the process proceeds back to step S117.

(S125) When the calculation up to l = L is complete, the process proceeds to step S126. Otherwise, the process proceeds back to step S116.

(S126) The feature value calculation unit 140 takes F = (F(0), F(1), ...) as a feature vector for the graph data set obtained at step S111. The feature value calculation unit 140 identifies a structure data set corresponding to the graph data set, and then stores the calculated feature vector in association with the identified structure data set in the storage unit 110.

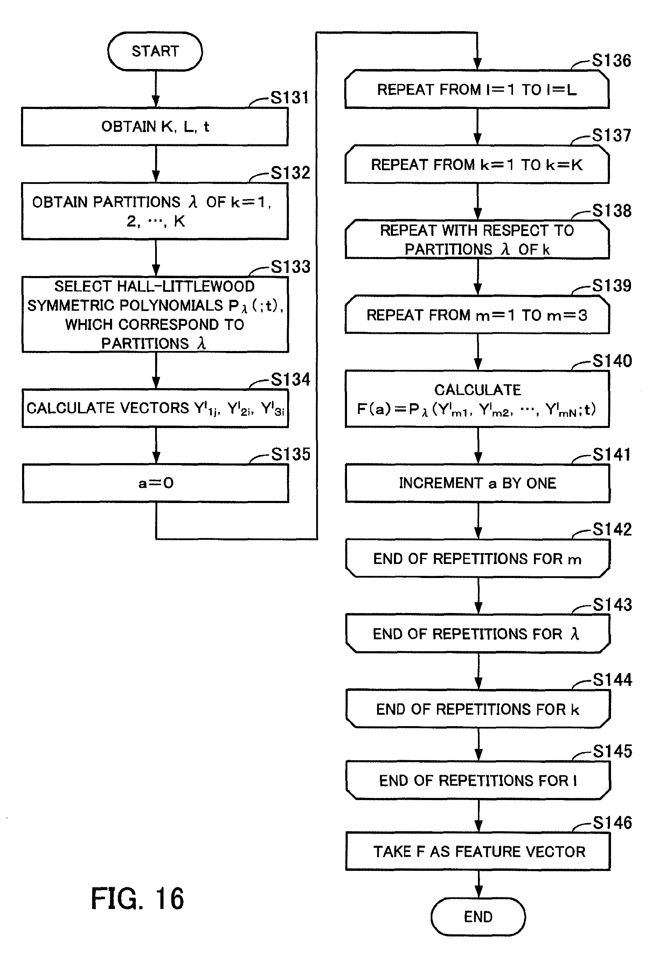

FIG. 16 is a flowchart illustrating a seventh example of how to calculate a feature vector. The process of FIG. 16 will be described step by step.

(S131) The feature value calculation unit 140 obtains a graph data set for which a feature vector is to be calculated and the parameters K, L, and t determined by the parameter setting unit 130.

(S132) The feature value calculation unit 140 obtains partitions λ of k (k is an integer satisfying $1 \le k \le K$). That is, the feature value calculation unit 140 obtains a plurality of partitions λ for each integer k = 1, 2, ..., K.

(S133) The feature value calculation unit 140 selects the Hall-Littlewood symmetric polynomials $P_\lambda(;t)$, which correspond to the partitions λ obtained at step S132.

(S134) The feature value calculation unit 140 calculates, with respect to the matrix $M^l$, vectors $Y^l_{1j}$, $Y^l_{2i}$, $Y^l_{3i}$ with the $\text{sum}_C$ operation, $\text{sum}_R$ operation, and diag operation, respectively, where the symbol 1 is an integer satisfying $1 \le l \le L$. The vectors $Y^l_{1j}$, $Y^l_{2i}$, $Y^l_{3i}$ are written as the equations (43), (44), and (45).

(S135) The feature value calculation unit 40 substitutes zero for the variable a.

(S136) The feature value calculation unit 140 substitutes 1 to L for 1 in order, and executes steps S137 to S144 for each substitution.

(S137) The feature value calculation unit 140 substitutes 1 to K for k in order, and executes steps S138 to S143 for each substitution.

(S138) The feature value calculation unit 140 executes steps S139 to S142 for each of all the partitions λ with respect to the current k.

(S139) The feature value calculation unit 140 substitutes 1, 2, and 3 for m in order, and executes steps S140 and S141 for each substitution.

(S140) The feature value calculation unit 140 calculates F(a) = $P_\lambda(Y^l;t)$ defined by the equation (52).

$$P_\lambda(Y^l; t) = P_\lambda(Y^l_{m1}, Y^l_{m2}, \ldots, Y^l_{mN}; t) \qquad (52)$$

(S141) The feature value calculation unit 140 increments the variable a by one.

(S142) When the calculation up to m = 3 is complete, the process proceeds to step S143. Otherwise, the process proceeds back to step S139.

(S143) When the calculation for all the partitions λ with respect to the current k is complete, the process proceeds to step S144. Otherwise, the process proceeds back to step S138.

(S144) When the calculation up to k = K is complete, the process proceeds to step S145. Otherwise, the process proceeds back to step S137.

(S145) When the calculation up to l = L is complete, the process proceeds to step S146. Otherwise, the process proceeds back to step S136.

(S146) The feature value calculation unit 140 takes F = (F(0), F(1), ...) as a feature vector for the graph data set obtained at step S131. The feature value calculation unit 140 identifies a structure data set corresponding to the graph data set, and then stores the calculated feature vector in association with the identified structure data set in the storage unit 110.

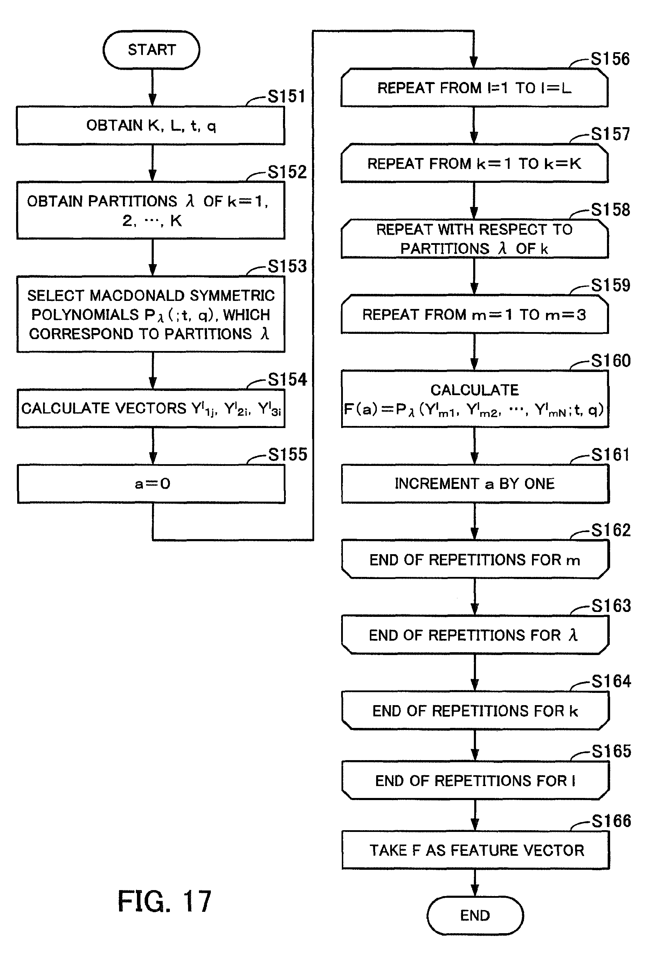

FIG. 17 is a flowchart illustrating an eighth example of how to calculate a feature vector. The process of FIG. 17 will be described step by step.

(S151) The feature value calculation unit 140 obtains a graph data set for which a feature vector is to be calculated and the parameters K, L, t, and q determined by the parameter setting unit 130.

(S152) The feature value calculation unit 140 obtains partitions λ of k (k is an integer satisfying 1 ≤ k ≤ K). That is, the feature value calculation unit 140 obtains a plurality of partitions λ for each integer k = 1, 2, ..., K.

(S153) The feature value calculation unit 140 selects the Macdonald symmetric polynomials $P_\lambda(;t, q)$, which correspond to the partitions λ obtained at step S152.

(S154) The feature value calculation unit 140 calculates, with respect to the matrix $M^l$, vectors $Y^l_{1j}$, $Y^l_{2i}$, $Y^l_{3i}$ with the $sum_C$ operation, $sum_R$ operation, and diag operation, respectively, where the symbol 1 is an integer satisfying 1 ≤ 1 ≤ L. The vectors $Y^l_{1j}$, $Y^l_{2i}$, $Y^l_{3i}$ are written as the equations (43), (44), and (45).

(S155) The feature value calculation unit 40 substitutes zero for the variable a.

(S156) The feature value calculation unit 140 substitutes 1 to L for 1 in order, and executes steps S157 to S164 for each substitution.

(S157) The feature value calculation unit 140 substitutes 1 to K for k in order, and executes steps S158 to S163 for each substitution.

(S158) The feature value calculation unit 140 executes steps S159 to S162 for each of all the partitions λ with respect to the current k.

(S159) The feature value calculation unit 140 substitutes 1, 2, and 3 for m in order, and executes steps S160 and S161 for each substitution.

(S160) The feature value calculation unit 140 calculates $F(a) = P_\lambda(Y^l; t, q)$ defined by the equation (53).

$$P_\lambda(Y^l; t, q) = P_\lambda(Y^l_{m1}, Y^l_{m2}, \ldots, Y^l_{mN}; t, q) \qquad (53)$$

(S161) The feature value calculation unit 140 increments the variable a by one.

(S162) When the calculation up to m = 3 is complete, the process proceeds to step S163. Otherwise, the process proceeds back to step S159.

(S163) When the calculation for all the partitions λ with respect to the current k is complete, the process proceeds to step S164. Otherwise, the process proceeds back to step S158.

(S164) When the calculation up to k = K is complete, the process proceeds to step S165. Otherwise, the process proceeds back to step S157.

(S165) When the calculation up to l = L is complete, the process proceeds to step S166. Otherwise, the process proceeds back to step S156.

(S166) The feature value calculation unit 140 takes F = (F(0), F(1), ...) as a feature vector for the graph data set obtained at step S151. The feature value calculation unit 140 identifies a structure data set corresponding to the graph data set, and then stores the calculated feature vector in association with the identified structure data set in the storage unit 110.

As described above, the computing apparatus 100 determines a degree and parameters for symmetric polynomials from a graph data set, and calculates feature values (or a feature vector including a plurality of kinds of feature values) corresponding to a structure data set with the symmetric polynomials. This approach makes it possible to efficiently calculate feature values appropriate for structure data search. The following describes the details.

There is a requirement that feature values of a graph for shape search are not affected by the numbering order of nodes (i.e., symmetric group invariance or may be called $S_N$ invariance, where the symbol $S_N$ denotes a symmetric group). If feature values of a certain shape vary depending on the numbering order of nodes, the structure data search is not conducted properly. The "numbering of nodes" may be considered to indicate in which order the weights of nodes and edges included in a graph are treated (for example, in the case where the weights of nodes are expressed as a vector, the numbering of nodes indicates which element is used to indicate the weight of a node).

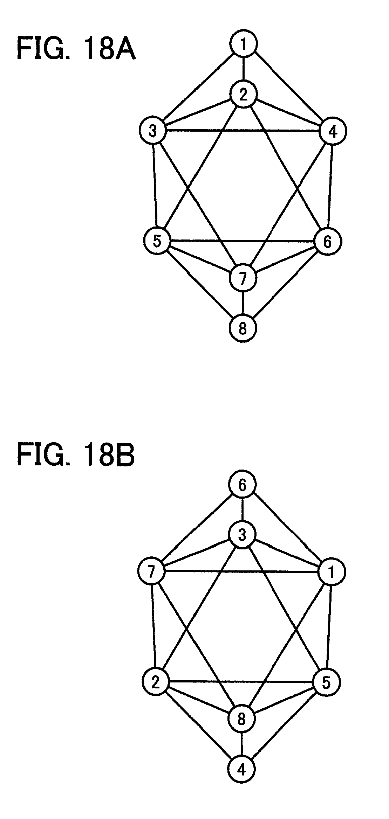

FIGS. 18A and 18B illustrate examples of numbering nodes. FIGS. 18A and 18B exemplify two patterns to assign numbers of 1 to 8 in a graph corresponding to a structure data set. In these examples, both graphs have the same shape, and therefore it is desirable that the same feature values are obtained.

Note that a computational cost problem occurs in converting values that are not symmetric group invariant (the weights of nodes and edges included in a graph data set) into values that are symmetric group invariant. For example, assuming that the number of nodes in a graph is N, the order of the symmetric group is N!, and therefore it is not easy to calculate a symmetric group invariant value (may be called an $S_N$ invariant value) from the weights of nodes and edges with taking all of the permutations into account. As exemplified in the first embodiment, the computational cost greatly increases with an increase in the number of nodes if an operation with a computational complexity of O(N!) is used. Therefore, with an increase in the number of vertices of a structure, a computational cost for calculating a feature value becomes considerable (for example, it is inefficient to calculate feature values for a complicated shape with a relatively large number of vertices). In addition, in the case of obtaining a plurality of kinds of feature values as a feature vector, the computational cost is more problematic if an operation with a computational complexity of O(N!) is performed to calculate each feature value. In addition, for example, to solve an NP-hard problem, such as calculating the number of cliques, needs a considerable computational cost, which is not realistic.

An operation that needs a considerable computational cost may be hard to be implemented for search. The computing apparatus 100 reduces the computational cost needed to calculate feature values, by using symmetric polynomials. The computing method of the second embodiment uses Newton symmetric polynomials to reduce a computational complexity to be as low as $O(N^2)$ for an operation of calculating a feature value. In addition, using symmetric polynomials other than the Newton symmetric polynomials, exemplified in the second embodiment, it is expected that a computational complexity is reduced to be as low as $O(e^N)$ for an operation of calculating a feature value.

Therefore, the computing apparatus 100 reduces the computational cost to calculate feature values, compared with the case of performing an operation with a computational complexity of O(N!). That is to say, to calculate a feature vector, the computational cost may be reduced, compared with the case of calculating all feature values through an operation with a computational complexity of O(N!). Specifically, using the Newton symmetric polynomials further reduces the computational cost, compared with the other kinds of symmetric polynomials.

At this time, the computing apparatus 100 determines a degree k and parameter 1 from a graph data set (information on a graph). As described earlier, the weights of nodes and edges are considered as information reflecting the shape of a structure. For example, as is seen from the equation (6), the number of times of multiplication of weight is obtained as the product kl of the degree k and parameter 1. In general, multiplication enlarges a difference between values. If differences in weight are reflected too much in feature values, a relatively small difference in shape produces a relatively large difference between feature values, which makes it difficult to evaluate similarity by comparison of feature values in searching. On the other hand, if the number times of multiplication is too few, the differences in weight may not adequately be reflected in feature values.

To deal with this, the computing apparatus 100 dynamically adjusts a degree k and parameter 1 on the basis of the information about the weights of a graph so that multiplication does not greatly enlarge differences in weight (and that differences in weight are adequately reflected in feature values) (for example, the equation (40)). This makes it possible to calculate feature values appropriate for searching for similar shapes. In addition, the computing apparatus 1 is able to limit the number of times of multiplication kl under a prescribed criterion, thereby making it possible to obtain feature values appropriate for search at a relatively low computational cost, compared with the case of using a fixed degree k and parameter l, irrespective of information on the graph, and thoughtlessly repeating multiplication.

In addition, in the example of the second embodiment, as the degree k and parameter 1 are greater, the number of kinds of feature values to be calculated increases. For example, 3KL feature values are calculated through the procedure of FIG. 10. In the case of K = L, as exemplified in FIG. 9, it is possible to reduce the number of times of multiplication of weight and the number of kinds of feature values so as not to increase the computational cost too much for calculating feature values.

In this connection, the computing apparatus 100 may determine a degree and parameters to be used in the operation of symmetric polynomials, on the basis of graph data sets corresponding to structure data sets other than a structure data set for which feature values are to be calculated. For example, when receiving a search query, the computing apparatus 100 calculates feature values (a feature vector) from the graph data set corresponding to the structure data set specified by the search query, and compares it with the feature values (feature vectors) of the structure data sets stored in the library. In this case, the computing apparatus 100 is able to calculate the feature values (the feature vector) corresponding to the structure data set specified by the search query, using the degree and parameter previously determined for a structure data set stored in the library. Note that the computing apparatus 100 may determine a degree and parameter on the basis of the graph data set corresponding to the structure data set specified by a search query.

The information processing of the first embodiment may be implemented by the operation unit 1b executing a program. The information processing of the second embodiment may be implemented by the processor 101 executing a program. Such a program is recorded on the computer-readable recording medium 13.

To distribute the program, for example, recording media 13 on which the program is recorded may be put on sale. Alternatively, the program may be stored in another computer and may be transferred from the other computer through a network. A computer stores (installs) the program recorded on the recording medium 13 or the program received from the other computer to a storage device, such as the RAM 102 or HDD 103, reads the program from the storage device, and then runs the program.

According to one aspect, it is possible to efficiently calculate feature values appropriate for structure data search.

**Claims**

1. A computing program that causes a computer to perform a process comprising:

   obtaining information on a graph corresponding to a structure data set, the structure data set representing a three-dimensional structure with a plurality of polygons;
   determining a degree and parameter to be used in an operation of a symmetric polynomial based on the information; and
   calculating a feature value of the graph corresponding to the structure data set with the symmetric polynomial using the determined degree and parameter.

2. The computing program according to claim 1, wherein the determining includes determining the degree and parameter based on a distribution of weights indicated in the information on the graph.

3. The computing program according to claim 2, wherein:

   the operation is that a number of times of multiplication of weight increases as the degree and parameter are greater; and
   the determining includes determining a smaller degree and smaller parameter when a relative error in weight is greater.

4. The computing program according to any one of claims 1 to 3, wherein the determining includes determining the degree and parameter based on information on a plurality of graphs corresponding to a plurality of structure data sets.

5. The computing program according to any one of claims 1 to 3, wherein the determining includes determining, for each of structure data sets for which feature values are to be calculated, the degree and the parameter based on information on a graph corresponding to said each structure data set.

6. The computing program according to any one of claims 1 to 4, wherein the calculating includes using a degree and parameter determined based on information on a graph corresponding to another structure data set.

7. The computing program according to any one of claims 1 to 6, wherein the calculating includes calculating the feature value by generating a matrix reflecting information about weights of nodes and edges included in the graph, transforming the matrix into a vector with a first kind of symmetric polynomial, and substituting elements of the vector into one of the first kind of symmetric polynomial and a second kind of symmetric polynomial.

8. The computing program according to any one of claims 1 to 7, wherein the calculating includes using one or more of a Newton symmetric polynomial, an elementary symmetric polynomial, a complete symmetric polynomial, a monomial symmetric polynomial, a Schur symmetric polynomial, a Jack symmetric polynomial, a Hall-Littlewood symmetric polynomial, and a Macdonald symmetric polynomial.

9. A computing apparatus comprising:

   storage means (1a) configured to store information on a graph corresponding to a structure data set, the structure data set representing a three-dimensional structure with a plurality of polygons; and
   operation means (1b) configured to perform a process including
   determining a degree and parameter to be used in an operation of a symmetric polynomial based on the information, and
   calculating a feature value of the graph corresponding to the structure data set with the symmetric polynomial using the determined degree and parameter.

10. A computing method comprising:

    obtaining, by a computer, information on a graph corresponding to a structure data set, the structure data set representing a three-dimensional structure with a plurality of polygons;
    determining, by the computer, a degree and parameter to be used in an operation of a symmetric polynomial based on the information; and
    calculating, by the computer, a feature value of the graph corresponding to the structure data set with the symmetric polynomial using the determined degree and parameter.

COMPUTING APPARATUS 1

STORAGE UNIT 1a — OPERATION UNIT 1b

(1.21, 3.5 ,0.64, ...)

FEATURE VALUE

STRUCTURE      WEIGHTED GRAPH      FEATURE VECTOR

# FIG. 1

COMPUTING APPARATUS  100

PROCESSOR  101

VIDEO SIGNAL PROCESSING UNIT  104

DISPLAY  11

RAM  102

INPUT SIGNAL PROCESSING UNIT  105

INPUT DEVICE  12

HDD  103

READER DEVICE  106

RECORDING MEDIUM  13

COMMUNI- CATION INTERFACE  107

NETWORK  10

FIG. 2

# FIG. 3A

NORMAL VECTOR r

K2 VERTEX

51

K1 VERTEX

VERTEX K3

z
y
x

EXEMPLARY POLYGON

# FIG. 3B

EXEMPLARY OCTAHEDRON

COMPUTING APPARATUS

100

110

GRAPH UNIT

120

STORAGE
UNIT

PARAMETER
SETTING UNIT

130

FEATURE VALUE
CALCULATION
UNIT

140

SEARCH UNIT

150

FIG. 4

FIG. 5A

FIG. 5B

FIG. 5C

EXEMPLARY STRUCTURE DATA SET

111

```
solid STRUCTURE A
facet normal r1 r2 r3
outer loop
vertex x1 y1 z1
vertex x2 y2 z2
vertex x3 y3 z3
endloop
endfacet
facet normal r4 r5 r6
outer loop
...
endloop
endfacet
...
endsolid
```

# FIG. 6

EXEMPLARY GRAPH DATA SET  112

```
<?xml version="1.0" encoding="UTF-8"?>
<graphml xmlns="http://···">
   <key id="key0" for="edge" attr.name="weight" attr.type="double" />
   <key id="key1" for="node" attr.name="weight" attr.type="double" />
   <graph id="G" edgedefault="undirected" parse.nodeids="canonical"
     parse.edgeids="canonical" parse.order="nodesfirst">
     <node id="n0">
       <data key="key1">3.3166</data>
     </node>
     <node id="n1">
       <data key="key1">3.3166</data>
     </node>
...
     </node>
     <edge id="e0" source="n1" target="n0">
       <data key="key0">1.4142</data>
     </edge>
     <edge id="e1" source="n2" target="n0">
       <data key="key0">1.4142</data>
     </edge>
...
     </edge>
   </graph>
</graphml>
```

# FIG. 7

FIG. 8

START

TAKE MEAN WEIGHT VALUE AS $\mu$ AND
STANDARD DEVIATION AS $\sigma$ ⌐S1

CALCULATE PARAMETERS K, L ⌐S2

CALCULATE PARAMETERS t, q, $\alpha$ ⌐S3

STORE K, L, t, q, $\alpha$ ⌐S4

END

FIG. 9

START

OBTAIN K, L — S11

SELECT ELEMENTARY SYMMETRIC POLYNOMIALS $e_k$ OF DEGREE k ($e_k = 0$ IN THE CASE OF k>N) — S12

CALCULATE VECTORS $Y^l_{1j}$, $Y^l_{2i}$, $Y^l_{3i}$ — S13

$a = 0$ — S14

REPEAT FROM l=1 TO l=L — S15

REPEAT FROM k=1 TO k=K — S16

REPEAT FROM m=1 TO m=3 — S17

CALCULATE $F(a) = e_k(Y^l_{m1}, Y^l_{m2}, \cdots, Y^l_{mN})$ — S18

INCREMENT a BY ONE — S19

END OF REPETITIONS FOR m — S20

END OF REPETITIONS FOR k — S21

END OF REPETITIONS FOR l — S22

TAKE F AS FEATURE VECTOR — S23

END

FIG. 10

START

S31
OBTAIN K, L

S32
SELECT COMPLETE SYMMETRIC
POLYNOMIALS $h_k$ OF DEGREE k
($h_k = 0$ IN THE CASE OF k>N)

S33
CALCULATE MATRIX $M^l$

S34
$a = 0$

S35
REPEAT FROM l=1 TO l=L

S36
REPEAT FROM k=1 TO k=K

S37
REPEAT FROM k'=1 TO k'=K

S38
CALCULATE $F(a) = h_k(h_{k'}(M^l))$

S39
INCREMENT a BY ONE

S40
END OF REPETITIONS FOR k'

S41
END OF REPETITIONS FOR k

S42
END OF REPETITIONS FOR l

S43
TAKE F AS FEATURE VECTOR

END

## FIG. 11

START

OBTAIN K, L — S51

OBTAIN PARTITIONS $\lambda$ OF k=1, 2, ···, K — S52

SELECT MONOMIAL SYMMETRIC POLYNOMIALS $m_\lambda$, WHICH ARE ASSOCIATED WITH PARTITIONS $\lambda$ — S53

CALCULATE MATRIX $M^l$ — S54

a=0 — S55

REPEAT FROM l=1 TO l=L — S56

REPEAT FROM k=1 TO k=K — S57

REPEAT WITH RESPECT TO PARTITIONS $\lambda$ OF k — S58

REPEAT WITH RESPECT TO PARTITIONS $\lambda'$ OF k — S59

CALCULATE $F(a) = m_\lambda(m_{\lambda'}(M^l))$ — S60

INCREMENT a BY ONE — S61

END OF REPETITIONS FOR $\lambda'$ — S62

END OF REPETITIONS FOR $\lambda$ — S63

END OF REPETITIONS FOR k — S64

END OF REPETITIONS FOR l — S65

TAKE F AS FEATURE VECTOR — S66

END

FIG. 12

36

START

S71
OBTAIN K, L

S72
SELECT NEWTON SYMMETRIC
POLYNOMIALS $p_k$ OF DEGREE k

S73
CALCULATE MATRIX $M^l$

S74
$a = 0$

S75
REPEAT FROM $l = 1$ TO $l = L$

S76
REPEAT FROM $k = 1$ TO $k = K$

S77
REPEAT FROM $k' = 1$ TO $k' = K$

S78
CALCULATE $F(a) = p_k(p_{k'}(M^l))$

S79
INCREMENT a BY ONE

S80
END OF REPETITIONS FOR $k'$

S81
END OF REPETITIONS FOR k

S82
END OF REPETITIONS FOR l

S83
TAKE F AS FEATURE VECTOR

END

FIG. 13

FIG. 14

START

↓

OBTAIN K, L — S91

↓

OBTAIN PARTITIONS $\lambda$ OF k=1, 2, ···, K — S92

↓

SELECT SCHUR POLYNOMIALS $s_\lambda$ AND MONOMIAL SYMMETRIC POLYNOMIALS $m_\lambda$, WHICH CORRESPOND TO PARTITIONS $\lambda$ — S93

↓

CALCULATE MATRIX $M^l$ — S94

↓

a=0 — S95

↓

REPEAT FROM l=1 TO l=L — S96

↓

REPEAT FROM k=1 TO k=K — S97

↓

REPEAT WITH RESPECT TO PARTITIONS $\lambda$ OF k — S98

↓

REPEAT WITH RESPECT TO PARTITIONS $\lambda'$ OF k — S99

↓

CALCULATE $F(a) = s_\lambda(m_\lambda \cdot (M^l))$ — S100

↓

INCREMENT a BY ONE — S101

↓

END OF REPETITIONS FOR $\lambda'$ — S102

↓

END OF REPETITIONS FOR $\lambda$ — S103

↓

END OF REPETITIONS FOR k — S104

↓

END OF REPETITIONS FOR l — S105

↓

TAKE F AS FEATURE VECTOR — S106

↓

END

START

OBTAIN K, L, $\alpha$ — S111

OBTAIN PARTITIONS $\lambda$ OF k=1, 2, ···, K — S112

SELECT JACK SYMMETRIC POLYNOMIALS $J_\lambda^{(\alpha)}$ AND SCHUR POLYNOMIALS $s_\lambda$, WHICH CORRESPOND TO PARTITIONS $\lambda$ — S113

CALCULATE MATRIX $M^I$ — S114

a=0 — S115

REPEAT FROM I=1 TO I=L — S116

REPEAT FROM k=1 TO k=K — S117

REPEAT WITH RESPECT TO PARTITIONS $\lambda$ OF k — S118

REPEAT WITH RESPECT TO PARTITIONS $\lambda$' OF k — S119

CALCULATE $F(a)=J_\lambda^{(\alpha)}(s_{\lambda'} \cdot (M^I))$ — S120

INCREMENT a BY ONE — S121

END OF REPETITIONS FOR $\lambda$' — S122

END OF REPETITIONS FOR $\lambda$ — S123

END OF REPETITIONS FOR k — S124

END OF REPETITIONS FOR I — S125

TAKE F AS FEATURE VECTOR — S126

END

FIG. 15

START

OBTAIN K, L, t — S131

OBTAIN PARTITIONS $\lambda$ OF k=1, 2, ···, K — S132

SELECT HALL-LITTLEWOOD SYMMETRIC POLYNOMIALS $P_\lambda(;t)$, WHICH CORRESPOND TO PARTITIONS $\lambda$ — S133

CALCULATE VECTORS $Y^l_{1j}$, $Y^l_{2i}$, $Y^l_{3i}$ — S134

a=0 — S135

REPEAT FROM l=1 TO l=L — S136

REPEAT FROM k=1 TO k=K — S137

REPEAT WITH RESPECT TO PARTITIONS $\lambda$ OF k — S138

REPEAT FROM m=1 TO m=3 — S139

CALCULATE $F(a)=P_\lambda(Y^l_{m1}, Y^l_{m2}, ···, Y^l_{mN};t)$ — S140

INCREMENT a BY ONE — S141

END OF REPETITIONS FOR m — S142

END OF REPETITIONS FOR $\lambda$ — S143

END OF REPETITIONS FOR k — S144

END OF REPETITIONS FOR l — S145

TAKE F AS FEATURE VECTOR — S146

END

FIG. 16

40

START

OBTAIN K, L, t, q —S151

OBTAIN PARTITIONS $\lambda$ OF k=1, 2, ···, K —S152

SELECT MACDONALD SYMMETRIC POLYNOMIALS $P_\lambda$ (;t, q), WHICH CORRESPOND TO PARTITIONS $\lambda$ —S153

CALCULATE VECTORS $Y^l_{1j}$, $Y^l_{2i}$, $Y^l_{3i}$ —S154

a=0 —S155

REPEAT FROM l=1 TO l=L —S156

REPEAT FROM k=1 TO k=K —S157

REPEAT WITH RESPECT TO PARTITIONS $\lambda$ OF k —S158

REPEAT FROM m=1 TO m=3 —S159

CALCULATE $F(a) = P_\lambda (Y^l_{m1}, Y^l_{m2}, ···, Y^l_{mN} ; t, q)$ —S160

INCREMENT a BY ONE —S161

END OF REPETITIONS FOR m —S162

END OF REPETITIONS FOR $\lambda$ —S163

END OF REPETITIONS FOR k —S164

END OF REPETITIONS FOR l —S165

TAKE F AS FEATURE VECTOR —S166

END

FIG. 17

41

FIG. 18A

FIG. 18B

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/311450 A1 (RAMANI KARTHIK [US] ET AL) 21 November 2013 (2013-11-21)<br>* abstract *<br>* paragraph [0244] - paragraph [0000] *<br>* paragraph [0320] *<br>* paragraph [0466] *<br>* paragraph [0469] - paragraph [0482] *<br>* paragraph [0487] *<br>----- | 1-10 | INV.<br>G06F17/50<br>G06F17/30 |
| X | EP 1 429 264 A2 (SAMSUNG ELECTRONICS CO LTD [KR]; SEOUL NAT UNIV IND FOUNDATION [KR]) 16 June 2004 (2004-06-16)<br>* abstract *<br>* paragraph [0012] - paragraph [0014] *<br>* paragraph [0032] - paragraph [0042]; figures 9-11 *<br>----- | 1-10 | |
| A | WO 01/46857 A2 (CA NAT RESEARCH COUNCIL [CA]) 28 June 2001 (2001-06-28)<br>* abstract *<br>* page 17, line 23 - page 18, line 15 *<br>----- | 1-10 | |

TECHNICAL FIELDS
SEARCHED      (IPC)

G06F

The present search report has been drawn up for all claims

| Place of search | Date of completion of the search | Examiner |
|---|---|---|
| Munich | 27 July 2015 | Sohrt, Wolfgang |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

&amp; : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 15 15 7546

This annex lists the patent family members relating to the patent documents cited in the above-mentioned European search report.
The members are as contained in the European Patent Office EDP file on
The European Patent Office is in no way liable for these particulars which are merely given for the purpose of information.

27-07-2015

| Patent document cited in search report | | | Publication date | Patent family member(s) | | | Publication date |
|---|---|---|---|---|---|---|---|
| US 2013311450 | A1 | | 21-11-2013 | EP<br>JP<br>JP<br>US<br>US<br>WO | 1586020<br>4516957<br>2006520948<br>2004249809<br>2013311450<br>2004068300 | A2<br>B2<br>A<br>A1<br>A1<br>A2 | 19-10-2005<br>04-08-2010<br>14-09-2006<br>09-12-2004<br>21-11-2013<br>12-08-2004 |
| EP 1429264 | A2 | | 16-06-2004 | CN<br>EP<br>JP<br>JP | 1527251<br>1429264<br>4166678<br>2004185626 | A<br>A2<br>B2<br>A | 08-09-2004<br>16-06-2004<br>15-10-2008<br>02-07-2004 |
| WO 0146857 | A2 | | 28-06-2001 | AU<br>CA<br>EP<br>JP<br>US<br>WO | 2337901<br>2394698<br>1242919<br>2003518294<br>6631364<br>0146857 | A<br>A1<br>A2<br>A<br>B1<br>A2 | 03-07-2001<br>28-06-2001<br>25-09-2002<br>03-06-2003<br>07-10-2003<br>28-06-2001 |

EPO FORM P0459

For more details about this annex : see Official Journal of the European Patent Office, No. 12/82

**EP 2 924 599 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006520948 A

- JP 2003518294 A

**Non-patent literature cited in the description**

- **IAN GRANT MACDONALD.** Symmetric functions and Hall polynomials second edition (Oxford Mathematical Monographs). Oxford University Press, 1995